# EUROPÄISCHE PATENTSCHRIFT

(11) **EP 1 266 546 B1**
(45) Veröffentlichungstag und Bekanntmachung des Hinweises auf die Patenterteilung: **26.10.2005**
(21) Anmeldenummer: 01927589.0
(22) Anmeldetag: 21.03.2001
(51) Int. Cl.: H05K 3/00

(54) **BEHANDLUNG VON SCHALTUNGSTRÄGERN MIT IMPULSARTIGER ANREGUNG**
TREATMENT OF CIRCUIT SUPPORTS WITH IMPULSE EXCITATION
TRAITEMENT DE SUPPORTS DE CIRCUITS AU MOYEN D'UNE EXCITATION PULSEE

(30) Priorität: 23.03.2000 DE 10015349
(43) Veröffentlichungstag der Anmeldung: 18.12.2002
(73) Patentinhaber: ATOTECH Deutschland GmbH, 10553 Berlin (DE)
(72) Erfinder: SCHRÖDER, Rolf, 90559 Burgthann (DE); DE BOER, Reinhard, 12107 Berlin (DE); GRAPENTIN, Hans-Joachim, 14059 Berlin (DE); CZECZKA, Regina, 14476 Gross Glienicke (DE)
(74) Vertreter: Effert, Bressel und Kollegen
(86) Internationale Anmeldenummer: PCT/DE2001/001127
(87) Internationale Veröffentlichungsnummer: WO 2001/072096

(56) Entgegenhaltungen:
- DE-A- 4 021 581
- DE-A- 4 322 378
- DE-A- 19 529 757
- DE-U- 9 011 675
- PATENT ABSTRACTS OF JAPAN vol. 014, no. 016 (E-872), 12. Januar 1990 (1990-01-12) & JP 01 258488 A (ELNA CO LTD), 16. Oktober 1989 (1989-10-16) in der Anmeldung erwähnt
- PATENT ABSTRACTS OF JAPAN vol. 004, no. 019 (C-073), 16. Februar 1980 (1980-02-16) -& JP 54 158337 A (FUJITSU LTD), 14. Dezember 1979 (1979-12-14)

## Beschreibung

Die Erfindung betrifft ein Verfahren und eine Vorrichtung zum Behandeln von durchgehende Löcher und/oder Vertiefungen aufweisenden Schaltungsträgern. Das Verfahren und die Vorrichtung sind insbesondere anwendbar zur Förderung der Benetzung von, zur Entfernung von Gasblasen aus und/oder zur Erhöhung des Stoffaustausches in durchgehenden Bohrungen und/oder Sackbohrungen in Leiterplatten.

Zur Herstellung von Leiterplatten, Leiterfolien und anderen Schaltungsträgern, beispielsweise Chipcarriem und Multichip-Modulen, werden galvanotechnische Verfahren eingesetzt, um die Leiterzüge auf den Außenseiten dieser Platten, Folien und Trägem zu erzeugen und um eine leitfähige Beschichtung an den Bohrungswänden zur elektrischen Verbindung mehrerer Leiterebenen zu bilden. Dabei werden vor allem Vorbehandlungsverfahren, Nachbehandlungsverfahren sowie Metallisierungsverfahren eingesetzt. Zu den Vorbehandlungsverfahren gehören u.a. Reinigungs-, Ätz- und Aktivierungsverfahren und zu den Nachbehandlungsverfahren Ätz-, Passivierungs- und andere Verfahren zur Erzeugung von Schutzschichten. Als Metallisierungsverfahren werden insbesondere elektrolytische, chemisch reduktive (stromlose) und zementative Verfahren eingesetzt.

Mit zunehmender Packungsdichte in den Schaltungsträgern werden Bohrungen mit immer geringerem Durchmesser gefordert. Die Behandlungsflüssigkeit kann nicht mehr ohne weiteres in derart enge Bohrungen eindringen. Auch die abschließende Entfernung von Flüssigkeit beim Trocknen ist nicht mehr ohne weiteres möglich. Der Stoffaustausch zwischen dem Behandlungsbad und dem Inneren der Bohrungen wird insbesondere dann sehr gering, wenn der Durchmesser der Bohrungen klein ist und gleichzeitig die Träger sehr dick sind. Maßgeblich für den Stoffaustausch ist das Verhältnis der Trägerdicke zum Bohrungsdurchmesser (Aspektenverhältnis). Weisen die Bohrungen bei durch den Träger hindurchgehenden Bohrungen ein Aspektenverhältnis von 6 : 1 und mehr auf, so kann es ohne zusätzliche Maßnahmen zur Verstärkung des Stoffaustausches zu Problemen bei der galvanotechnischen Behandlung kommen. Insbesondere sogenannte Sacklöcher, die nur von einer Seite in das Trägermaterial hineinreichen, können mit den Behandlungsflüssigkeiten nur noch mit Schwierigkeiten behandelt werden. Ein Aspektenverhältnis von 1 : 1 kann bei diesen teilweise sehr kleinen Bohrungen (Durchmesser beispielsweise 100 µm) bereits zu erheblichen Problemen führen.

Zur Behebung dieser Schwierigkeiten sind bereits zahlreiche Vorschläge gemacht worden. Beispielsweise werden die in einem Tauchbad behandelten Leiterplatten senkrecht zur Plattenoberfläche langsam hin- und herbewegt, um eine Durchströmung zumindest der durchgehenden Bohrungen zu erreichen. Zusätzlich wird teilweise auch Luft in die Behandlungsbäder eingeleitet, um dadurch eine starke Konvektion in den Bädern zu erzeugen. Allerdings wurde sehr schnell erkannt, daß diese Maßnahmen nicht ausreichen, um die sehr kleinen Bohrungen mit einem Durchmesser von 0,5 mm und weniger wirkungsvoll zu durchströmen.

Zur Abhilfe der Probleme wird in DE 30 11 061 A1 ein Verfahren zur Intensivierung von Spül- und Reinigungsprozessen für Bohrungen in Leiterplatten beschrieben. Hierzu werden die Leiterplatten auf einem horizontalen Transportweg und in horizontaler Betriebslage durch eine Behandlungsanlage befördert und dabei über eine sogenannte Spülmittelschwallstrecke geführt, von der aus das flüssige Spülmittel über Schlitzrohre an die Unterseite der Leiterplatten gefördert wird. Das Spülmittel gelangt somit auch in die sich nach unten öffnenden Bohrungen. Damit können Lacke und flüssige Ätzmittel aus den Löchern und anderen Durchbrüchen in den Leiterplatten wirkungsvoll ausgespült werden.

Eine ähnliche Anordnung zum Reinigen, Aktivieren und/oder Metallisieren von Bohrlöchern in horizontal geführten Leiterplatten ist in EP 0 212 253 B1 angegeben. Auch in diesem Falle werden die in horizontaler Betriebslage geführten Leiterplatten an einer Einrichtung vorbeigeführt, die eine unterhalb der Transportbahn sowie senkrecht zur Transportrichtung angeordnete Düse aufweist. Als Düse wird eine Schwalldüse eingesetzt, aus der das flüssige Behandlungsmittel senkrecht gegen die Plattenseiten gefördert wird.

Eine weitere Verbesserung besteht nach EP 0 329 807 B1 darin, zusätzlich zu einer Schwalldüse eine an einer Oberfläche der in horizontaler Richtung und in einer horizontalen Betriebslage geführten Platte angeordnete Absaugung auf der der Schwalldüse abgewandten Seite der Platte vorzusehen. Als zusätzlicher Vorteil wird dabei angesehen, daß eine Ablagerung von ausgespülten Verunreinigungen auf den Plattenoberflächen vermieden werden soll.

In DE 40 40 119 C2 ist ein Verfahren zum Durchfluten von Bohrungen in Leiterplatten angegeben, die in horizontaler Betriebslage und Transportrichtung befördert werden. Zur Förderung von Behandlungflüssigkeit sind Walzen vorgesehen, die einander gegenüberliegend an beiden Seiten der Leiterplatten anliegen. Im Betrieb wird die Behandlungsflüssigkeit der einen Walze (Düsenwalze) über den Hohlraum zugeführt, tritt durch deren Austrittsöffnungen aus, die im Kontakt zwischen der Düsenwalze und der Platte geöffnet sind, passiert die Plattenbohrungen und gelangt in die ebenfalls hohle Gegendruckwalze durch Eintrittsöffnungen. In den Austrittsöffnungen der Düsenwalze sind Ventile vorgesehen, die mit einem flüssigkeitsdurchlässigen Mantelkörper fest verbunden sind. Werden die Ventile aus dem Ventilsitz gehoben, strömt die Flüssigkeit durch den freigegebenen Ringspalt aus und gelangt zu den Bohrungen.

In EP 0 752 807 A1 ist eine weitere Vorrichtung zur Behandlung von Leiterplatten beschrieben. Die Leiterplatten werden in horizontaler Betriebslage und Transportrichtung an Einrichtungen vorbei geführt, die jeweils aus einem geschlitzten Rohr und einer in dem Rohr angeordneten Transportwalze bestehen. Der Rohrschlitz ist zur Transportebene geöffnet. Die Transportwalze ragt mit einem Teil aus dem Schlitz heraus, um die Platten mitzunehmen. Zwischen den Schlitzbegrenzungen und der Walze sind schmale Spalte gebildet, aus denen in das Rohr unter Druck geförderte Behandlungsflüssigkeit austreten und zu den Platten und durch die Löcher in den Platten gelangen kann.

Eine andere Möglichkeit zur Intensivierung des Stoffaustausches in den Bohrungen besteht darin, mittels Vibrationseinrichtungen eine Verbesserung der Flüssigkeitsdurchströmung in den Bohrungen zu erreichen.

In EP 0 586 770 A1 ist hierzu ein Gestell zur Halterung von Teilen mit galvanotechnisch mit Schwierigkeiten zu behandelnden Löchern beschrieben, an dem mindestens ein Vibrator an einer zur Halterung von Behandlungsgut dienenden Tragschiene und beabstandet zu den Auflagestellen der Tragschiene auf einem Behälterrand angebracht ist. In diesem Falle wird die erforderliche Flüssigkeitszirkulation in den Löchern durch die mit dem Vibrator auf das Gestell und damit auf die daran befestigten Teile übertragenen Schwingungen erzeugt.

Eine ähnliche Einrichtung ist in EP 0 446 522 A1 beschrieben, die zur stromlosen Verkupferung von Leiterplatten dienen soll. Diese Einrichtung weist einen Behälter zur Aufnahme des stromlosen Abscheidebades, ein Gestell zur Halterung der in das Abscheidebad eingetauchten Leiterplatten und einen Vibrator zur Erzeugung von Vibrationsschwingungen in den Leiterplatten auf. Der Vibrator ist an der einen Korb haltenden Trägerstange befestigt, in dem die Leiterplatten gestapelt gehalten werden.

Eine Vorrichtung zur Entfernung von Verunreinigungen (Bohrmehl) aus Bohrungen von Leiterplatten ist in Patent Abstracts of Japan zu JP-A-1258488 offenbart, in der die Leiterplatten in horizontaler Richtung und horizontaler Betriebslage durch eine Behandlungsflüssigkeit geführt werden, wobei Vibrationsschwingungen im Ultraschallbereich in der Nähe der Transportebene für die Leiterplatten auf die Behandlungsflüssigkeit übertragen werden, so daß die an den Ultraschallerzeugem vorbeigeführten Leiterplatten diesen Schwingungen ausgesetzt werden.

Eine Anordnung zur Erzeugung von Vibrationsschwingungen in in horizontaler Richtung und in horizontaler Betriebslage geführten Leiterplatten ist in WO 96/21341 A1 und in DE 43 22 378 A1 beschrieben. In diesem Falle werden die Leiterplatten in eine kombinierte Bewegung versetzt, die durch Vibrationsschwingungen, in den Leiterplatten mit einem Unwuchtvibrator vorzugsweise mit einer Frequenz oberhalb von etwa 1 Hz erzeugt, und eine gleitende Vorwärtsbewegung gebildet ist. Die Vibrationsschwingungsbewegungen sind vorzugsweise kreisförmig oder kreisähnlich, wobei die Kreisebene in der Plattenebene oder senkrecht dazu angeordnet sein kann. Die Bewegungen können auch linear sein. Sie folgen vorzugsweise einer Sinuskurve. Die Leiterplatten in eine derartige Kombinationsbewegung zu versetzen und dabei beispielsweise Galvanisierstrom zu übertragen, ist äußerst aufwendig.

In WO 92/01088 A1 sind ein Verfahren und eine Vorrichtung zur Bewegung von Bohrungen aufweisenden Leiterplatten bei der Galvanisierung offenbart. Die Leiterplatten sind in diesem Falle an Traggestellen befestigt und werden in senkrechter Lage in eine Galvanisierflüssigkeit eingetaucht. Das dort beschriebene Verfahren wird vorzugsweise bei Leiterplatten mit Bohrungen angewendet, die ein Aspektenverhältnis von mindestens 8 : 1 aufweisen. Zur Entfernung von Rückständen in den Bohrungen werden die Platten mit einer Frequenz von mindestens 4 bis 5 Hz gerüttelt, wobei die in den Platten erzeugten Schwingungen mindestens teilweise in Richtung der Längsachse der Bohrungen verlaufen und wobei die Rüttelschwingungen nur oder zumindest überwiegend auf das Traggestell der Leiterplatten ausgeübt werden. Die Schwingungserzeuger sind an einem Transport- und/oder Tragteil für die Leiterplatten angebracht. In dem Dokument wird darauf hingewiesen, daß mit diesem Verfahren und der Vorrichtung auch bei chemischen bzw. elektrochemischen Prozessen entstehende Gasbläschen aus den Bohrungen entfernt werden können. Ferner wird auch vorgeschlagen, während der Rüttelung Schläge bzw. schlagartige Stöße auf die Leiterplatten auszuüben, um das Ablösen der Gasbläschen zu erleichtern.

In DE 90 11 675 U1 ist eine Vorrichtung zur Oberflächenbehandlung und Galvanisierung von Leiterplatten beschrieben. Die Leiterplatten werden zur galvanotechnischen Behandlung in vertikaler Lage in die Behandlungsflüssigkeiten eingetaucht. Hierzu sind die Platten an einem Traggestell befestigt, das in der Behandlungsflüssigkeit zusammen mit den Leiterplatten langsam hin- und herbewegt wird. Es wird darauf hingewiesen, daß in den Bohrungen bei einem erstmaligen Kontakt mit den Behandlungsflüssigkeiten Gasbläschen verbleiben, die insbesondere aus Bohrungen mit einem großen Aspektenverhältnis nur mit Schwierigkeiten entfernbar sind. Eine bekannte Methode zur Erschütterung der Platten durch manuellen Schlag mit einem Hammer oder Klopfer sei teuer und besitze nur geringen Einfluß auf die kontinuierliche Verbesserung des Stoffaustausches in der Grenzschicht an der Bohrungswand. Außerdem sei der Erfolg bei Mehrlagenschaltungen mit bis zu 30.000 Bohrungen mit Durchmessern von 0,3 mm, in denen sich Bläschen befinden können, zweifelhaft. Um diese Probleme zu lösen, wird in dem Dokument vorgeschlagen, der langsamen Bewegung des Traggestelles mit den daran befestigten Leiterplatten eine vergleichsweise schnelle Relativbewegung zwischen der Behandlungsflüssigkeit und dem darin befindlichen Werkstück zu überlagern. Die Frequenz der schnellen Relativbewegung liege im Infraschall- oder Schallbereich. Zur Erzeugung der Schwingungsbewegung wird als mechanische Vibrationseinrichtung ein mechanischer Schwinger oder Rüttler eingesetzt.

In DE 195 29 757 A ist ein Verfahren zur Entgasung von Bohrungen in Platten offenbart, bei dem die Platten mit Hilfe einer Transporteinrichtung auf einem teilweise horizontalen Transportweg und teilweise in einer Transportebene befördert und dabei mit einer Behandlungsflüssigkeit durch Eintauchen in Kontakt gebracht werden. Mittels eines Elektrodensystems werden Hochleistungspulse durch Funkenentladung in der Behandlungsflüssigkeit erzeugt. Die Hochleistungspulse heben die Oberflächenspannung der Gase in den Bohrungen auf und drücken gleichzeitig die Flüssigkeit in die Bohrungen.

Die bekannten Verfahren und Vorrichtungen sind jedoch nicht geeignet oder zu aufwendig, um insbesondere Gasbläschen aus sehr kleinen Bohrungen, insbesondere Sackbohrungen, auch in horizontalen Durchlaufanlagen sicher auszutreiben. Außerdem ist der Stoffaustausch in Sackbohrungen mit den bekannten Verfahren und Vorrichtungen bisher nicht befriedigend gelöst worden.

Der vorliegenden Erfindung liegt von daher das Problem zugrunde, die Nachteile der bekannten Verfahren und Vorrichtungen zu vermeiden und insbesondere eine Vorrichtung und ein Verfahren zu finden, mit dem die Entfernung von Gasbläschen aus Durchgangsbohrungen in Schaltungsträgern mit einem sehr großen Aspektenverhältnis, beispielsweise von 15 : 1 und größer, und aus Sackbohrungen mit sehr kleinen Durchmessern, beispielsweise kleiner als 0,2 mm, und relativ großen Aspektenverhältnissen, beispielsweise mindestens 0,8 : 1, sicher gelingt. Außerdem sollen das Verfahren einfach durchzuführen und die Vorrichtung ohne wesentlichen apparativen Aufwand realisierbar sein.

Gelöst wird dieses Problem durch die Vorrichtung nach Anspruch 1, das Verfahren nach Anspruch 11, die Verwendung der Vorrichtung nach Anspruch 21 und die Anwendung des Verfahrens nach Anspruch 22. Bevorzugte Ausführungsformen der Erfindung sind in den Unteransprüchen angegeben.

Die erfindungsgemäße Vorrichtung dient zum Behandeln von durchgehende Löcher und/oder Vertiefungen aufweisenden Schaltungsträgern. Insbesondere ist die Vorrichtung zur Förderung der Benetzung von, zur Entfernung von Gasblasen aus und/oder zur Erhöhung des Stoffaustausches in durchgehenden Bohrungen und/oder Sackbohrungen in Leiterplatten geeignet, wobei vor allem durchgehende Bohrungen mit einem Aspektenverhältnis von 15 : 1 und mehr und Sackbohrungen mit einem Aspektenverhältnis von 0,8 : 1 und mehr sicher behandelt werden können. Insbesondere können die erfindungsgemäße Vorrichtung und das Verfahren bei den galvanotechnischen Verfahrensschritten zur Herstellung von Leiterplatten eingesetzt werden, beispielsweise bei der Reinigung, Vorbehandlung und Metallisierung sowie weiterer Verfahrensarten. Die Erfindung ist vorteilhaft einsetzbar zur Entfernung von Gasbläschen bei der erstmaligen Benetzung der Bohrungen in Schaltungsträgern, bei der Entfernung von Verunreinigungen aus den Bohrungen bei der Reinigung und beim Stoffaustausch in den Bohrungen zum Transport von frischer Behandlungsflüssigkeit zu den zu behandelnden Oberflächen (beispielsweise bei der Metallisierung).

Die erfindungsgemäße Vorrichtung weist Einrichtungen zum In-Kontakt-Bringen von Behandlungsflüssigkeit mit den Schaltungsträgern auf, beispielsweise Düsen, wie Schwall-, Spritz- und Sprühdüsen. Die Vorrichtung kann auch derart ausgebildet sein, daß die zu behandelnden Schaltungsträger durch ein aufgestautes Bad der Behandlungsflüssigkeit hindurchgeführt werden. In diesem Falle umfassen die Einrichtungen zum In-Kontakt-Bringen der Behandlungsflüssigkeit mit den Schaltungsträgern beispielsweise die Zuleitungen für die Flüssigkeit in den Raum, in dem die Schaltungsträger geführt werden, sowie Aufstaumittel, wie Quetschwalzen und/oder Behälterwände.

Außerdem weist die erfindungsgemäße Vorrichtung Transportmittel und gegebenenfalls separate Haltemittel für die Schaltungsträger auf, mit denen die Schaltungsträger auf einem horizontalen Transportweg und in einer Transportebene beförderbar sind. Die Transportmittel können auch als Halte- und Führungsmittel für die Schaltungsträger ausgebildet sein sowie zur Stromzuführung dienen. Als Halte-, Transport- und Führungsmittel können seitlich angreifende Klammern oder Greifer, rotierende Mittel, wie Rollen, Räder und Walzen, sowie Schlepp- oder Schubvorrichtungen, beispielsweise in Form von Klammern, eingesetzt werden.

Ferner sind Impulserzeugungsmittel vorgesehen, mit denen die Schaltungsträger über die Transportmittel mechanisch impulsartig anregbar sind. Unter einer impulsartigen Anregung sind solche Schwingungsformen zu verstehen, die, anders als beispielsweise sinusartige Schwingungen, abrupte Bewegungsänderungen in den Schaltungsträgern verursachen. Beispielsweise sind darunter schlag- bzw. stoßartige bzw. klopfende Anregungen zu verstehen. Auch sich ständig wiederholende Anregungen werden als impulsartige Anregungen angesehen, beispielsweise im wesentlichen Rechteck- oder auch Sägezahnform aufweisende Schwingungen, d.h. solche mit einem hohen Anteil von höherfrequenten Oberschwingungen, wenn sie im vorgenannten Sinne abrupte Bewegungsänderungen in den Schaltungsträgern verursachen. Die Repetierrate der impulsartigen Anregungen kann im Infraschall- oder Schallbereich liegen. Die Breite der Impulse sollte so gewählt werden, daß eine möglichst wirksame Entfernung von Gasbläschen und ein möglichst wirksamer Stoffaustausch in erfindungsgemäßer Weise möglich ist. Typischerweise werden Schläge bzw. Rechteckimpulse mit einer Pulsbreite von mindestens 50 msec angewendet.

Unter den Impulserzeugungsmitteln sind also nicht solche Mittel zu verstehen, die lediglich Schwingungen in den Schaltungsträgern erzeugen, beispielsweise Rüttler und Vibratoren. Auch die Verwendung von Ultraschallquellen, die mit der Behandlungsflüssigkeit in Kontakt stehen, werden nicht als erfindungsgemäße Impulserzeugungsmittel angesehen, da diese ebenfalls sinusförmige Schwingungen erzeugen und da die mit diesen Quellen erzeugten hochfrequenten Schwingungen die Schaltungsträger wegen deren hierfür zu großer Masse nicht zu erregen vermögen.

Es hat sich nämlich herausgestellt, daß allein eine Anregung durch Schläge, Stöße oder durch Klopfen geeignet ist, die erfindungsgemäßen Wirkungen zu erbringen.

Insbesondere zur Förderung der Benetzung von, zur Entfernung von Gasblasen aus und/oder zur Erhöhung des Stoffaustausches in durchgehenden Bohrungen und/oder Sackbohrungen in Leiterplatten werden die Schaltungsträger mit Hilfe der Transportmittel auf dem horizontalen Transportweg und in einer Transportebene befördert und dabei mit der Behandlungsflüssigkeit in Kontakt gebracht. Mit den Impulserzeugungsmitteln werden mechanische Impulse direkt, über die Transportmittel und/oder über die Behandlungsflüssigkeit auf die Schaltungsträger übertragen. Die erfindungsgemäßen Vorrichtungen können auch durch einfache Nachrüstung in bereits bestehenden Behandlungsanlagen mit relativ einfachen Mitteln und kostengünstig realisiert werden. Oft ist es ausreichend, die erfindungsgemäße Vorrichtung nur am Einlauf der Schaltungsträger in die Behandlungszone anzubringen, um ein Benetzen der Schaltungsträgeroberflächen mit der Behandlungsflüssigkeit zu gewährleisten.

Die Impulserzeugungsmittel können insbesondere derart angeordnet und ausgebildet sein, daß Impulse mit senkrecht auf die Schaltungsträgeroberfläche wirkenden Impulskomponenten erzeugbar sind. In diesem Falle werden im wesentlichen senkrecht auf die Schaltungsträgeroberfläche wirkende Impulse erzeugt. Gegebenenfalls können die Impulse nämlich auch horizontale Impulskomponenten aufweisen. Impulse mit Impulskomponenten, die senkrecht auf die Schaltungsträgeroberfläche wirken, sind besonders vorteilhaft, da die Anregung der Schaltungsträger in diesem Falle wirkungsvoller gelingt als bei Verwendung von Impulsen, die im wesentlichen parallel zur Schaltungsträgeroberfläche wirken, da zur wirksamen Einkoppelung der Impulse in die Schaltungsträger eine ausreichend große Traktion der Impulserzeugungsmittel mit der Schaltungsträgeroberfläche bestehen muß. Außerdem stehen die Achsen der Bohrungen im allgemeinen ebenfalls senkrecht auf der Schaltungsträgeroberfläche, so daß ein im wesentlichen senkrecht zur Oberfläche wirkender Impuls auch wirksamer zum Stoffaustausch oder zur Entfernung von Gasbläschen beitragen kann als im wesentlichen parallel zur Oberfläche wirkende Impulse. Im wesentlichen senkrecht wirkende Impulse können ohne weiteres durch auf den Oberflächen aufliegende Impulserzeugungsmittel eingekoppelt werden. Senkrecht wirkende Impulse können sowohl von unten als auch von oben auf die Schaltungsträger ausgeübt werden.

Eine besonders wirksame Behandlung der kleinen durchgehenden Bohrungen und Sacklöcher wird dann erreicht, wenn die Schaltungsträger auf einem im wesentlichen horizontalen Transportweg befördert werden. Dadurch können die Schaltungsträger in geringem Abstand an den Düsen vorbeigeführt werden, so daß die Behandlungsflüssigkeit mit starker Strömung an die Schaltungsträgeroberflächen und in die Bohrungen gefördert werden kann. Insbesondere werden gleichbleibende Strömungsverhältnisse für alle Oberflächenbereiche dadurch erzielt, daß der Abstand der Düsenöffnungen von den Oberflächen konstant gehalten werden kann. Bei der praktischen Erprobung hat sich gezeigt, daß mit der erfindungsgemäßen Vorrichtung und dem Verfahren auch Leiterfolien mit sehr geringer Dicke behandelt werden können, während bekannte Methoden in diesem Falle versagen.

Vorzugsweise werden rotierende Transportmittel eingesetzt. In diesem Falle können die Impulserzeugungsmittel derart angeordnet und ausgebildet sein, daß die Impulse durch eine Rotation der Transportmittel erzeugbar und/oder steuerbar sind. Bevorzugte Ausführungsformen, bei denen die Impulse über die Rotation erzeugt und/oder gesteuert werden, sind nachfolgend exemplarisch dargestellt.

In einer ersten bevorzugten Ausführungsform der Erfindung werden zumindest teilweise Transportwalzen als Transportmittel eingesetzt. Diese Transportwalzen oder zumindest einige dieser Walzen weisen jeweils einen im wesentlichen zylinderförmigen Hohlraum auf. An der im wesentlichen zylinderförmigen Innenwand des Hohlraumes erstreckt sich jeweils mindestens ein Vorsprung in axialer Richtung, der gegebenenfalls unterbrochen sein kann. Außerdem ist in dem Hohlraum jeweils mindestens ein Körper als Impulserzeugungsmittel enthalten, der beim Rotieren der Transportwalzen an der Innenwand abrollt, durch den Vorsprung mitgenommen wird, beim Weiterrotieren den Vorsprung überspringt, dabei von dem Vorsprung herunterfällt und nach unten auf die Innenwand der Transportwalze auftrifft. Dadurch werden Impulse auf die Transportwalzen und von den Transportwalzen auf die Schaltungsträger übertragen. In dem Hohlraum können auch mehrere Vorsprünge vorgesehen sein, die sich jeweils in axialer Richtung erstrecken, wobei diese Vorsprünge in regelmäßigen oder unregelmäßigen Abständen entlang des Umfanges der Innenwand zueinander beabstandet sind. Derartige Transportmittel werden nachfolgend als Klopfwalzen bezeichnet.

Als sich in axialer Richtung erstreckende Vorsprünge sind beispielsweise durchgehende Stolperleisten, aber auch unterbrochene Leisten sowie aus einzelnen noppenartigen Erhöhungen bestehende Vorsprünge, die auf einer sich axial erstreckenden Linie angeordnet sind, zu verstehen. Die Höhe der in den Hohlraum ragenden Vorsprünge muß so bemessen sein, daß der im Hohlraum nicht befestigte Körper bei der Rotation der Transportwalze bei einer Umdrehung der Transportwalze zumindest teilweise mitgenommen wird, beispielsweise bei einer Rotation um etwa 90°. Die Größe des Körpers steht dabei in unmittelbarer Beziehung zur Höhe der Vorsprünge: Wird ein kleinerer Körper verwendet, kann auch der Vorsprung kleiner sein, und umgekehrt. Die Größe des Körpers und die Größe des daran angepaßten mindestens einen Vorsprunges müssen so groß sein, daß der Körper beim Überspringen des Vorsprunges und beim anschließenden Auftreffen auf den unteren Bereich der Walzeninnenwand einen merklichen Impuls auf die Walze erzeugt, der auf die Schaltungsträger übertragen wird.

Der Körper ist vorzugsweise im wesentlichen zylinderförmig ausgebildet und weist ein möglichst hohes Gewicht auf, um einen möglichst starken Impuls beim Auftreffen auf die Walzeninnenwand zu erzeugen, wobei auch der Fallweg zu berücksichtigen ist: Bei größerem Fallweg und/oder Gewicht wird ein größerer Impuls erzeugt als bei geringerem Fallweg und/oder Gewicht. Beispielsweise kann der Körper ein Stahlstab sein, der im wesentlichen ebenso lang ist wie der Hohlraum. Dadurch wird ein großes axiales Spiel des Körpers im Hohlraum vermieden. Insbesondere wird ein umso stärkerer Impuls erzeugt, je größer der Durchmesser der Transportwalzen ist, da in diesem Falle der Fallweg für den Körper länger ist.

In einer alternativen Ausführungsform ist der Hohlraum der Transportwalze nicht zylinderförmig. Vielmehr weist der Hohlraum im wesentlichen axial verlaufende Innenkanten auf. Der Querschnitt des Hohlraumes ist in diesem Falle vorzugsweise quadratisch. Ein sich in dem Hohlraum befindender Körper als Impulserzeugungsmittel rollt auf den Seitenflächen des Hohlraumes ab, wenn die Transportwalze in Drehung versetzt wird. Da der Körper dabei von einer Innenkante des Hohlraumes in die nächste fällt, werden Impulse von dem Körper auf die Walze und von dieser auf die Schaltungsträger übertragen.

Die Schaltungsträger werden vorzugsweise in einer horizontalen Transportebene durch die Behandlungsanlage geführt. Die Klopfwalzen können oberhalb oder unterhalb oder an beiden Seiten der Transportebene, beispielsweise wechselweise oberhalb und unterhalb der Transportebene, angeordnet werden. Die von der Klopfwalze ausgehenden Impulse werden repetierend auf die Schaltungsträger übertragen, wobei die Impulsfrequenz von der Drehgeschwindigkeit der Walze und damit von deren Durchmesser und der Vorschubgeschwindigkeit der Schaltungsträger abhängt.

Alternativ können Impulse auch durch eine hammerartige Vorrichtung auf die Schaltungsträger übertragen werden. Beispielsweise kann ein Hammer an der Oberseite oder der Unterseite der Transportebene so angeordnet sein, daß er beim Passieren der Schaltungsträger auf deren Oberfläche klopft. Der Hammer kann durch die Rotation der Transportmittel angetrieben bzw. gesteuert werden.

In einer anderen erfindungsgemäßen Ausführungsform sind die Transportmittel zumindest teilweise mit jeweils mindestens einem Rad, das am Umfang mit jeweils mindestens einem Vorsprung versehen ist, so verbunden und zusammen mit dem mindestens einen Rad mit einer gemeinsamen Achse drehbar so gelagert und jeweils ein federnder oder federnd gelagerter Klopfer als Impulserzeugungsmittel am Umfang des mindestens einen Rades so anliegend angeordnet, daß durch den Klopfer beim Übergleiten über den Vorsprung mechanische Impulse auf das mindestens eine Rad und damit auf die mit dem mindestens einen Rad vorzugsweise starr verbundenen Transportmittel und von den Transportmitteln auf die Schaltungsträger übertragen werden.

Beispielsweise können ein Rad oder mehrere Räder zusammen mit einer Transportwalze oder mit Rollen oder Rädern auf einer gemeinsamen Achse befestigt sein, so daß das Rad oder die Räder durch die Drehung der Transportwalze, der Rollen oder der Räder mitgedreht werden.

Das Rad kann beispielsweise einen Vorsprung oder mehrere Vorsprünge am Umfang aufweisen, die zueinander beabstandet sind. Falls mehrere Vorsprünge vorgesehen sind, können diese in regelmäßigen oder unregelmäßigen Abständen zueinander am Umfang des Rades angeordnet sein. In einer besonders bevorzugten Ausführungsform sind die Räder ratschenartig ausgebildet, d.h. das Rad weist einen sägezahnartigen Umfang auf.

Der an dem Umfang des Rades oder der Räder anliegende Klopfer kann als Hebel ausgebildet sein, der beispielsweise durch eine Feder vorgespannt ist und gegen den Umfang gedrückt wird. In einer anderen Ausführungsform kann der Klopfer auch als Stift ausgebildet sein, der in im wesentlichen tangentialer oder auch radialer Richtung auf den Umfang federnd gedrückt wird, beispielsweise durch eine mechanische Feder oder mit pneumatischen Mitteln.

Durch die Rotation der Transportwalze, der Räder oder der Rollen rotieren die die Vorsprünge aufweisenden Räder ebenfalls, so daß der Klopfer über den mindestens einen Vorsprung gleitet und beim Abgleiten von dem mindestens einen Vorsprung jeweils durch die Federkraft stark beschleunigt gegen den Radumfang geschlagen wird, so daß mechanische Impulse auf das Rad und die mit dem Rad verbundene Transportwalze bzw. die Räder oder Rollen und von diesen wiederum auf die Schaltungsträger übertragen werden. Die Federkraft und die Masse des Klopfers müssen so bemessen sein, daß ausreichend starke mechanische Impulse beim Schlagen des Klopfers gegen den Radumfang erzeugt werden.

Die Impulserzeugungsmittel dieser Ausführungsform können sowohl bei horizontal als auch bei vertikal ausgerichteter Transportebene eingesetzt und bei Führung der Schaltungsträger in einer horizontalen Transportebene sowohl oberhalb als auch unterhalb der Transportebene angeordnet sein. Es werden insbesondere repetierende Impulse auf die Schaltungsträger ausgeübt. Die Impulsfrequenz richtet sich nach der Drehgeschwindigkeit der Transportmittel und hängt somit vom Durchmesser der Transportmittel als auch von der Vorschubgeschwindigkeit der Schaltungsträger ab.

In einer weiteren erfindungsgemäßen Ausführungsform werden die Transportmittel zumindest teilweise mit jeweils einem magnetischen Kern ausgerüstet. Als Transportmittel kommen vorzugsweise Transportwalzen in Frage. Jeweils mindestens ein Elektromagnet ist als Impulserzeugungsmittel den mit dem magnetischen Kern ausgerüsteten Transportmitteln derart zugeordnet, daß mit einer pulsförmigen Einspeisung von Strom in den Elektromagneten eine Kraft auf die mit dem magnetischen Kern ausgerüsteten Transportmittel in der Weise ausübbar ist, daß über die Transportmittel schlagartige mechanische Impulse in den Schaltungsträgern erzeugt werden.

Beispielsweise kann der magnetische Kern aus einem ferromagnetischen Material, beispielsweise Stahl, bestehen, so daß beim Einspeisen von Strom in den Elektromagneten eine anziehende Kraft zwischen dem Elektromagneten und dem ferromagnetischen Kern wirkt und das Transportmittel von den Schaltungsträgern abgehoben wird.

Die Transportmittel können auch mit einem magnetisierten Material (Permanentmagnet) ausgerüstet sein. Durch die Rotation der Transportmittel wird auch der Permanentmagnet rotierend bewegt. Ist der Permanentmagnet in den Transportmitteln derart angeordnet, daß die Magnetpole radial ausgerichtet sind, so weist zeitweise der eine Pol und zeitweise der andere Pol des Magneten zum Elektromagneten. Wird die Richtung des Magnetfeldes des Elektromagneten zeitlich nicht verändert, so kann je nach Drehlage des Permanentmagneten eine abstoßende oder anziehende Wirkung auf das Transportmittel ausgeübt werden. Durch Synchronisation einer Pulsfolge des Magnetfeldes des Elektromagneten kann das Transportmittel somit entweder pulsartig vom Elektromagneten angezogen oder von diesem abgestoßen werden. Auch eine abwechselnd anziehende und abstoßende Wirkung kann durch geeignete Einspeisung von Pulsstrom in den Elektromagneten erzielt werden. Diese Ausführungsform ist sehr vorteilhaft, weil damit mechanische Impulse in wechselnder Richtung auf die Schaltungsträger ausgeübt werden, so daß Gasbläschen, die sich in den kleinen Bohrungen befinden, leichter abgelöst werden können. Indem andererseits pulsierender Strom beispielsweise immer dann in den Elektromagneten eingespeist wird, wenn sich eine abstoßende Wirkung auf die Transportmittel ergibt, können ausschließlich mechanische Stoßimpulse auf die Transportmittel und damit auf die Schaltungsträger übertragen werden.

Vorzugsweise kann auch eine weitere zu den Schaltungsträgern gerichtete Kraft, beispielsweise die Schwerkraft und/oder eine Federkraft und/oder eine magnetische Kraft, auf die Transportmittel wirken. In diesem Falle ist es möglich, durch Verwendung eines ferromagnetischen Kerns oder durch Synchronisation der Strompulse mit der Transportmittelrotation bei Verwendung eines Permanentmagneten in den Transportmitteln eine gegen diese weitere Kraft wirkende Kraft auf die Transportmittel auszuüben, so daß die Transportmittel von den Schaltungsträgern angehoben werden. Beim Abschalten des Elektromagneten wird das Transportmittel durch diese weitere Kraft wieder auf die Schaltungsträger zurückbewegt, so daß auf diese Weise beim Auftreffen des Transportmittels auf die Schaltungsträgeroberflächen mechanische Impulse auf die Schaltungsträger übertragen werden. Dies setzt natürlich voraus, daß die weitere Kraft kleiner ist als die durch den Elektromagneten ausgeübte Kraft. Wird als weitere Kraft lediglich die Schwerkraft ausgenutzt, so kann das Transportmittel, beispielsweise eine Transportwalze, oberhalb einer horizontal ausgerichteten Transportebene angeordnet sein. Falls repetierende Impulse auf die Schaltungsträger ausgeübt werden sollen, richtet sich die Impulsfrequenz nach der Rückfallzeit des Transportmittels auf die Schaltungsträger, nachdem dieses von dem Elektromagneten angehoben worden ist.

Wird ein Permanentmagnet in den Transportmitteln eingesetzt, so können die Impulserzeugungsmittel nach dieser weiteren Ausführungsform sowohl bei horizontal als auch bei vertikal ausgerichteter Transportebene eingesetzt und bei Führung der Schaltungsträger in horizontaler Transportebene sowohl oberhalb als auch unterhalb der Transportebene angeordnet sein. Die Impulse können repetierend angewendet werden, wobei die Impulsfrequenz von der Ausführungsvariante abhängt: Wird eine Variante gewählt, bei der die Repetierrate durch die Drehung der Transportmittel gesteuert wird, so hängt die Impulsfrequenz vom Durchmesser und von der Vorschubgeschwindigkeit der Schaltungsträger und damit von der Drehfrequenz der Transportmittel ab. Andernfalls kann eine beliebige Impulsfrequenz angewendet werden, wobei allerdings eine obere Grenze durch die Massenträgheit des Gesamtsystems gegeben ist.

Die vorstehend angegebenen Ausführungsformen der vorliegenden Erfindung können - wie dort beschrieben - für sich genommen ausgeführt werden. Es ist aber auch möglich, Kombinationen der einzelnen Ausführungsformen zu verwenden, um zum einen mehrere Impulserzeugungsmittel in einer Behandlungsanlage nebeneinander zu betreiben und um zum anderen kombinatorische Lösungen für die Impulserzeugung zu realisieren. Beispielsweise können mittels Elektromagneten erzeugte Impulse zusätzlich verstärkt werden, indem die Walzen, auf die die elektromagnetische Kraft wirkt, als Klopfwalzen ausgebildet sind, in denen sich zur Impulserzeugung Metallstäbe in den hohlen Walzen befinden.

Zur näheren Erläuterung der erfindungsgemäßen Vorrichtung und des Verfahrens wird auf die nachfolgenden Figuren verwiesen. Es zeigen:
- **Fig. 1:**: einen schematischen Schnitt durch eine Durchlaufanlage;
- **Fig. 2:**: einen Querschnitt einer Klopfwalze mit einer Stolperleiste;
- **Fig. 3:**: einen Querschnitt einer Klopfwalze mit vier Stolperleisten;
- **Fig. 4:**: Querschnitte durch eine Klopfwalze in verschiedenen Rotationsstadien;
- **Fig. 5:**: einen Querschnitt durch eine Klopfwalze mit quadratischem Innenquerschnitt;
- **Fig. 6:**: eine Draufsicht auf ein als Ratsche ausgebildetes Impulserzeugungsmittel;
- **Fig. 7A:**: eine Ansicht eines als Ratsche ausgebildeten Impulserzeugungsmittels von der Stirnseite;
- **Fig. 7B:**: eine Ansicht eines als Ratsche ausgebildeten Impulserzeugungsmittels von der Stirnseite;
- **Fig. 7C:**: ein Detail zu dem als Ratsche ausgebildeten Impulserzeugungsmittel;
- **Fig. 7D:**: eine Ansicht eines als Ratsche ausgebildeten Impulserzeugungsmittels von der Stirnseite;
- **Fig. 8:**: eine Seitenansicht eines Impulserzeugungsmittels mit einem Elektromagneten (teilweise geschnitten);
- **Fig. 9**: ein als Ratsche ausgebildetes Impulserzeugungsmittel.

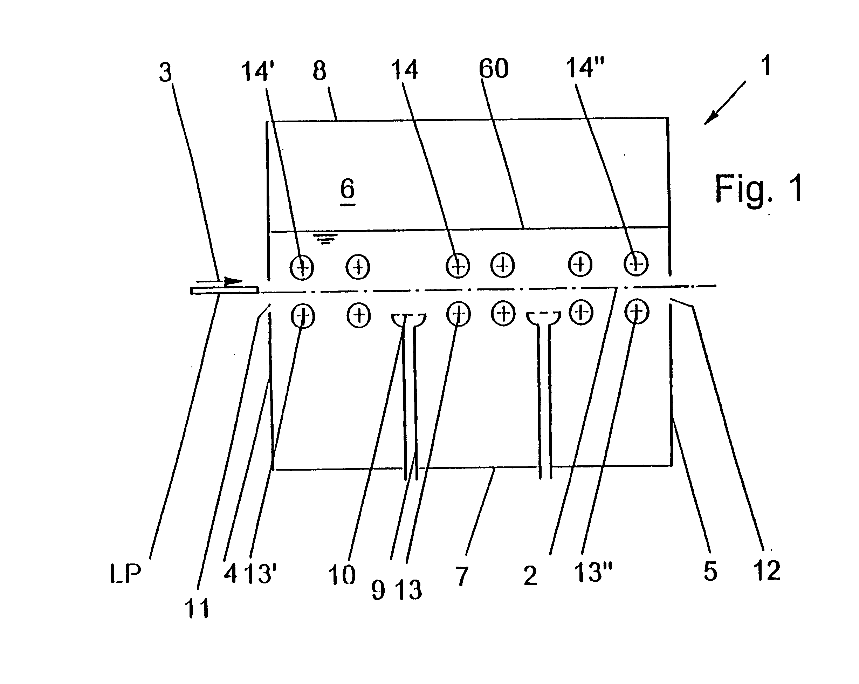

In **Fig. 1** ist eine Seitenansicht einer Behandlungsanlage mit einer Behandlungskammer **1** angegeben, in der Leiterplatten **LP** in einer horizontalen Transportebene **2** in der Transportrichtung **3** geführt werden. Die Kammer **1** ist aus einer Eintrittswand **4** und einer Austrittswand **5,** Seitenwänden **6,** einem Kammerboden **7** und einem Kammerdeckel **8** gebildet. Behandlungsflüssigkeit befindet sich in einem nicht dargestellten Reservoir, vorzugsweise unterhalb der Behandlungskammer **1.** Die Behandlungsflüssigkeit wird über Rohrleitungen **9** zu den Düsen **10** gefördert. Die Düsen **10** sind als Schwalldüsen ausgebildet. Hierzu weisen diese beispielsweise eine Düsenkammer mit einem zur Transportebene **2** hin ausgerichteten Schlitz auf. Die aus den Düsen **10** austretende Behandlungsflüssigkeit wird in die Bohrungen in den Leiterplatten **LP** hinein und gegebenenfalls durch diese hindurch gefördert. Die Flüssigkeit fließt zu dem Flüssigkeitsreservoir über nicht dargestellte Öffnungen wieder ab, nachdem sie mit den Leiterplatten **LP** in Kontakt gebracht worden ist.

Die Leiterplatten **LP** werden in der Transportrichtung **3** durch den Eintrittsschlitz **11** in der Eintrittswand **4** in die Kammer **1** befördert. Sie werden durch die Kammer **1** hindurchgeführt und durch den Austrittsschlitz **12** in der Austrittswand 5 wieder aus der Kammer **1** herausgeführt.

Innerhalb der Kammer **1** sind Transportwalzen **13** und **14** vorgesehen, von denen die Transportwalzen **13** unterhalb und die Transportwalzen **14** oberhalb der Transportebene **2** angeordnet sind. Die Transportwalzen **13,14** dienen zur Führung und zum Transport der Leiterplatten **LP** in der Kammer **1.** Sie bestehen an der Außenseite zumindest teilweise aus einem elastischen Material, um eine Beschädigung der Oberflächen der Leiterplatten **LP** zu vermeiden und um eine möglichst große Traktion zwischen den Walzen **13,14** und den Leiterplatten **LP** zu erreichen.

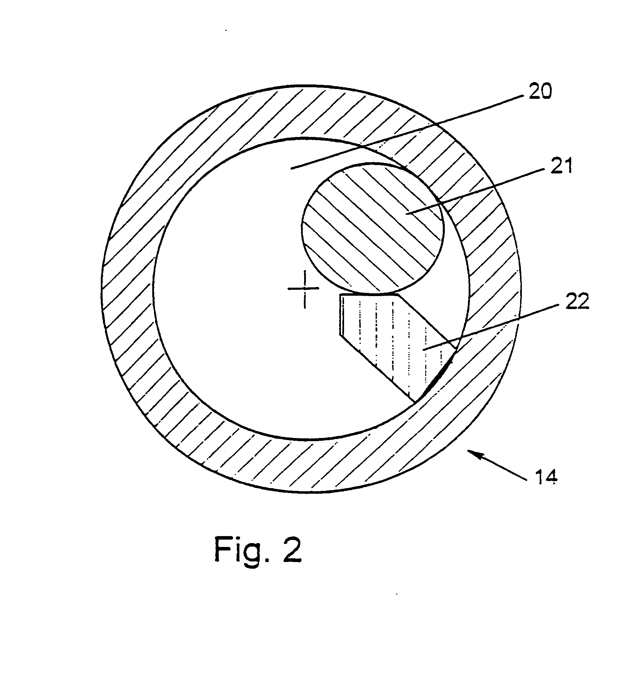

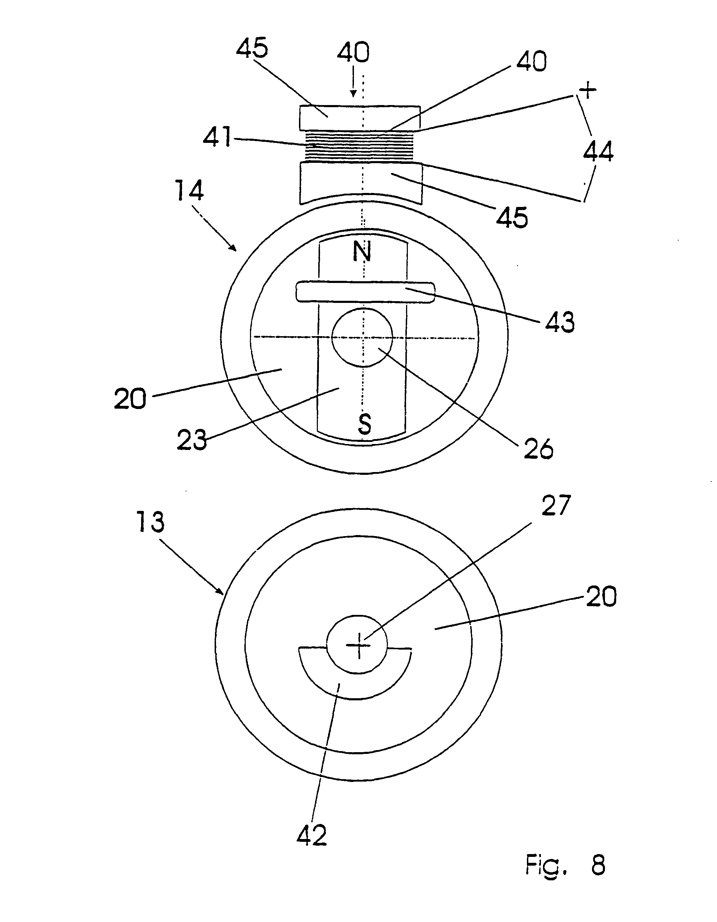

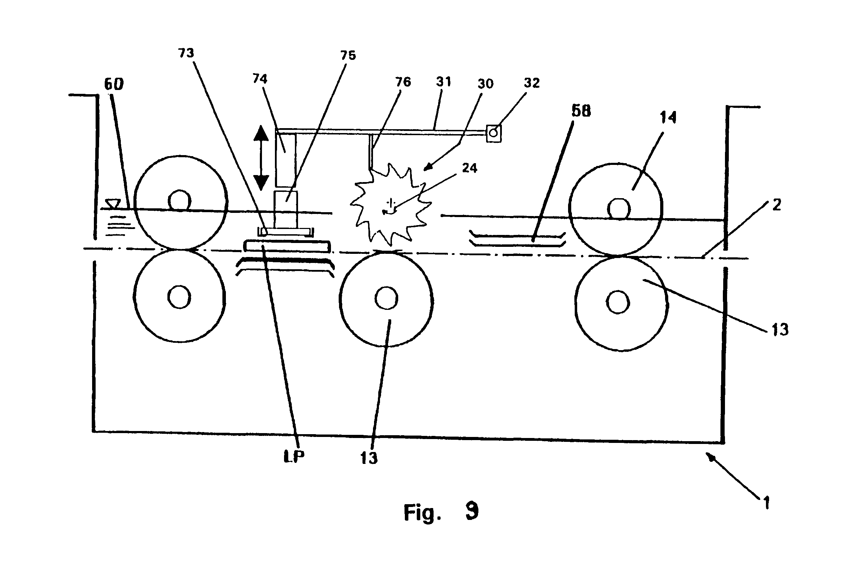

Die oberhalb und unterhalb der Transportebene **2** angeordneten Transportwalzen **13** und **14** können mit erfindungsgemäßen Impulserzeugungsmitteln **21,31** (**Fig. 2** bis **7**) versehen sein. Ferner können auch Impulserzeugungsmittel **40** vorgesehen sein (**Fig. 8**). In einer besonderen Ausführungsform können auch oberhalb und/oder unterhalb der Transportebene **2** angeordnete Impulserzeugungsmittel **50** zwischen den Transportwalzen **14** vorgesehen sein (**Fig. 9)** . Gegebenenfalls muß sich hierzu auch oberhalb der Transportebene **2** Behandlungsflüssigkeit befinden, um die in den Impulserzeugungsmitteln **50** erzeugten mechanischen Impulse über die Flüssigkeit in die Leiterplatten **LP** einkoppeln zu können. Hierzu wird der Abfluß der Behandlungsflüssigkeit aus der Kammer **1** in das Flüssigkeitsreservoir so geregelt, daß die Kammer **1** bis zu einem Niveau **60** oberhalb der Transportebene **2** gefüllt ist. Die am Eintrittsschlitz **11** angeordneten Walzen **13'** und **14'** und die am Austrittsschlitz **12** angeordneten Walzen **13"** und **14"** dienen auch als Abquetschwalzen zum Zurückhalten von Behandlungsflüssigkeit und verhindern oder behindern zumindest deren Austritt aus der Kammer **1.**

In **Fig. 2** ist eine Ausführungsform einer Transportwalze **14** mit einem Hohlraum **20** und einem in dem Hohlraum **20** liegenden Metallstab **21** als Impulserzeugungsmittel im Querschnitt dargestellt. An der Innenwand des Hohlraumes **20** ist eine Stolperleiste **22** angebracht. Der Metallstab **21** ist in dem Hohlraum **20** nicht befestigt. Die Länge des Metallstabes **21** ist etwas geringer als die axiale Länge des Hohlraumes **20.** Dadurch wird gewährleistet, daß der Metallstab **21** nur geringes Spiel in axialer Richtung hat.

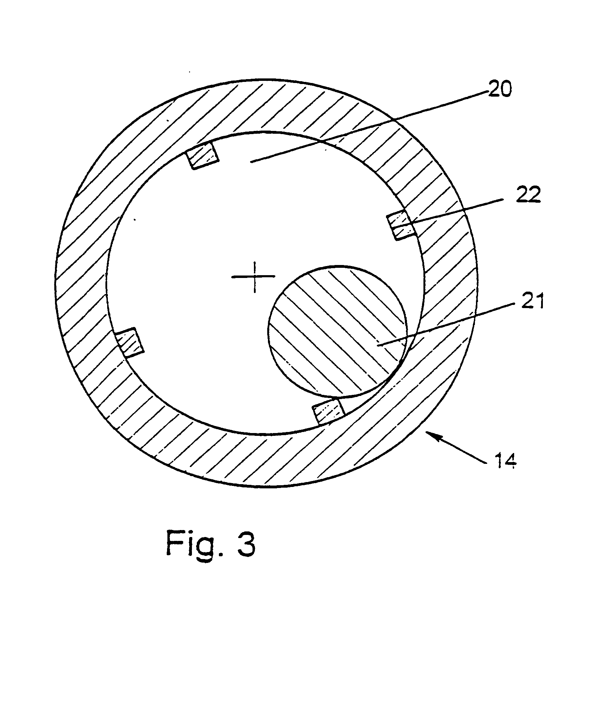

In **Fig. 3** ist eine weitere Variante einer Transportwalze **14** mit einem Hohlraum **20** und einem in dem Hohlraum **20** liegenden Metallstab **21** im Querschnitt dargestellt. In diesem Falle sind vier jeweils um 90° zueinander versetzte Stolperleisten **22** angebracht. Auch in diesem Falle ist der Metallstab **21** in dem Hohlraum **20** nicht befestigt.

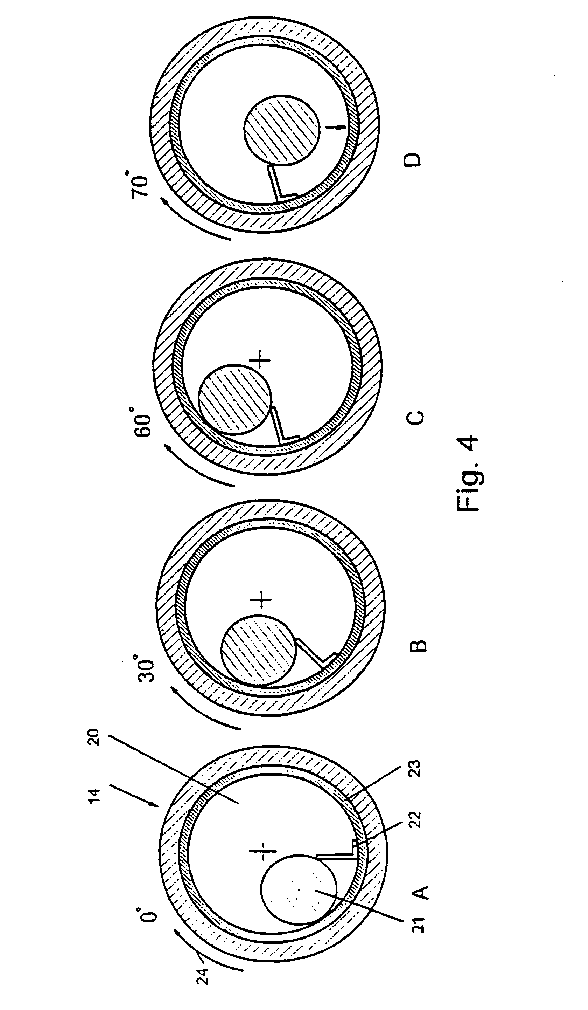

In **Fig. 4** ist die Funktionsweise der mit dem Hohlraum **20** und einer Stolperleiste **22** versehenen Transportwalze **13,14** in verschiedenen Rotationsstadien dargestellt. In diesem Falle ist zusätzlich auf der Innenseite der ansonsten nicht aus Metall bestehenden Transportwalze **14** ein Metallzylinder **23** eingesetzt, der der Transportwalze **14** die erforderliche Stabilität verleiht. Die Walze **14** rotiert in der gezeigten Drehrichtung **24.**

In **Fig. 4A** ist die Walze **14** mit der Stolperleiste **22** am untersten Punkt dargestellt. In dieser Lage hat die Leiste **22** den Stab **21** aus der untersten Lage bereits etwas angehoben. Bei weiterer Rotation gemäß **Fig. 4B** ist die Leiste **22** bereits um etwa 30° weitergedreht und der Stab **21** von ihr ebenfalls um diesen Abschnitt mitgenommen worden. In **Fig. 4C** ist die Walze **14** um weitere 30° gedreht worden. Die Leiste **22,** die den Stab **21** mitgenommen hat, ist ebenfalls um weitere 30° mitgedreht worden. Bei weiterer Drehung der Walze **14** springt der Stab **21** über die Leiste **22** und fällt auf den untersten Punkt der Innenwand. Dabei wird ein mechanischer Impuls auf die Walze **14** übertragen und der Impuls auf eine mit der Walze **14** in Kontakt stehende Leiterplatte **LP** (**Fig. 1**). Bei weiterer Drehung der Walze **14** rollt der Stab **21** zunächst an der Innenwand des Hohlraumes **20** ab und wird erst wieder von der Leiste **22** mitgenommen, sobald diese den Stab **21** vor sich her schieben kann.

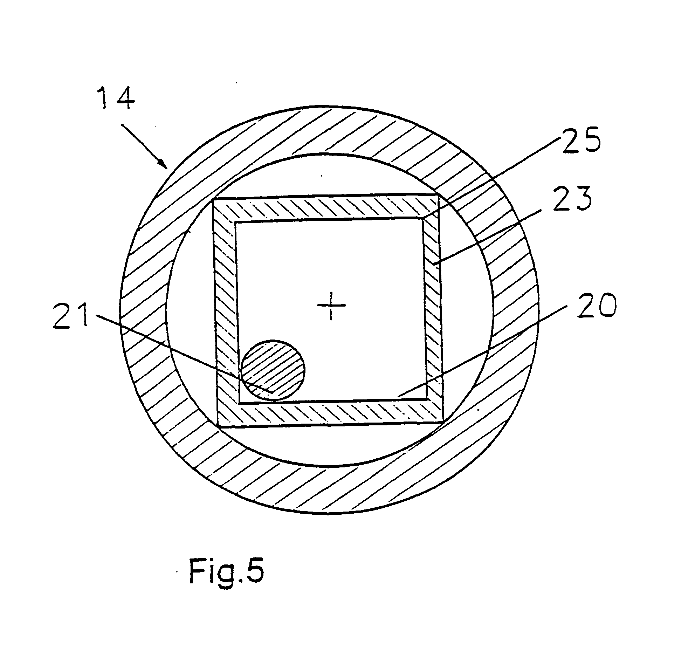

In **Fig. 5** ist eine weitere Variante einer Klopfwalze **14** dargestellt. In diesem Falle weist der Hohlraum **20** in der Walze **14** einen quadratischem Querschnitt auf. Innerhalb der Walze **14** ist hierzu ein Vierkantrohr **23** mit quadratischem Querschnitt eingelassen. Ein Metallstab **21** fällt in diesem Falle bei der Rotation der Walze **14** von einer Ecke (Innenkante) **25** in die nächste, so daß auf diesem Wege Impulse auf die Walze **14** und von dieser auf die Leiterplatten **LP** ausgeübt werden.

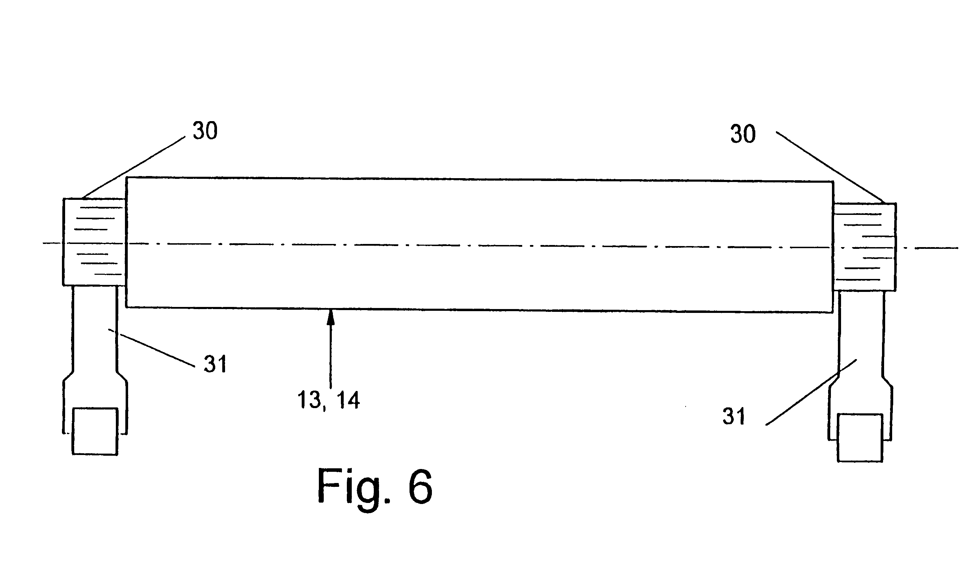

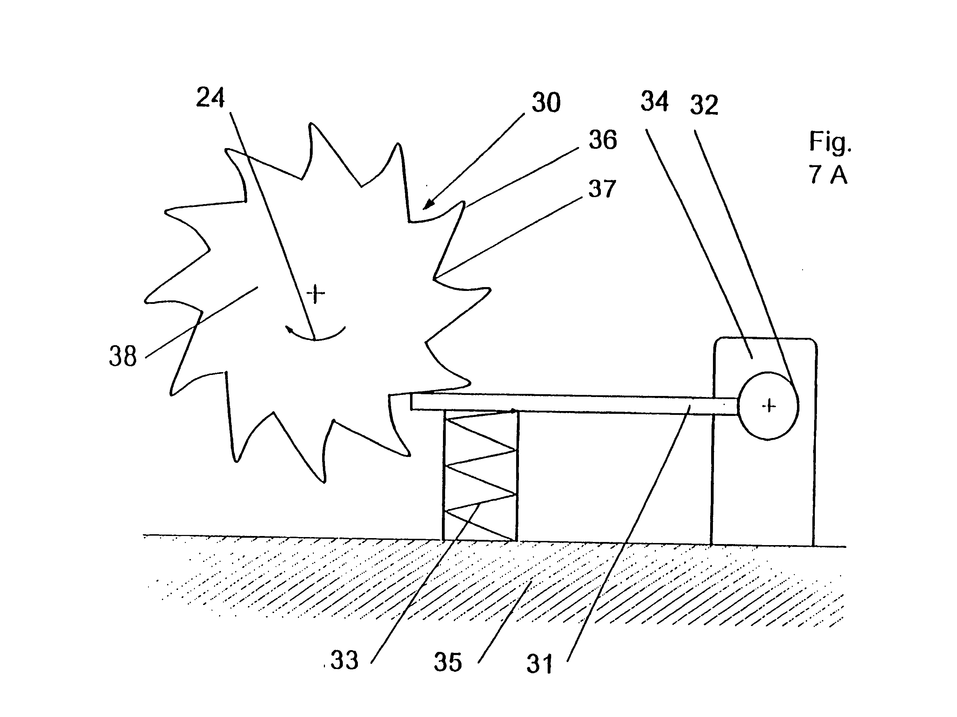

In **Fig. 6** ist die Draufsicht auf eine Transportwalze **13,14** mit jeweils einer an den beiden Stirnseiten befestigten Ratsche **30** dargestellt. Die Ratschen **30** liegen auf derselben Achse wie die Walze **13,14** und sind mit dieser fest verbunden.

Am Umfang der Ratschen **30** liegen jeweils Klopfer **31** unter Federkraft an, die in Lagern auslenkbar angeordnet sind.

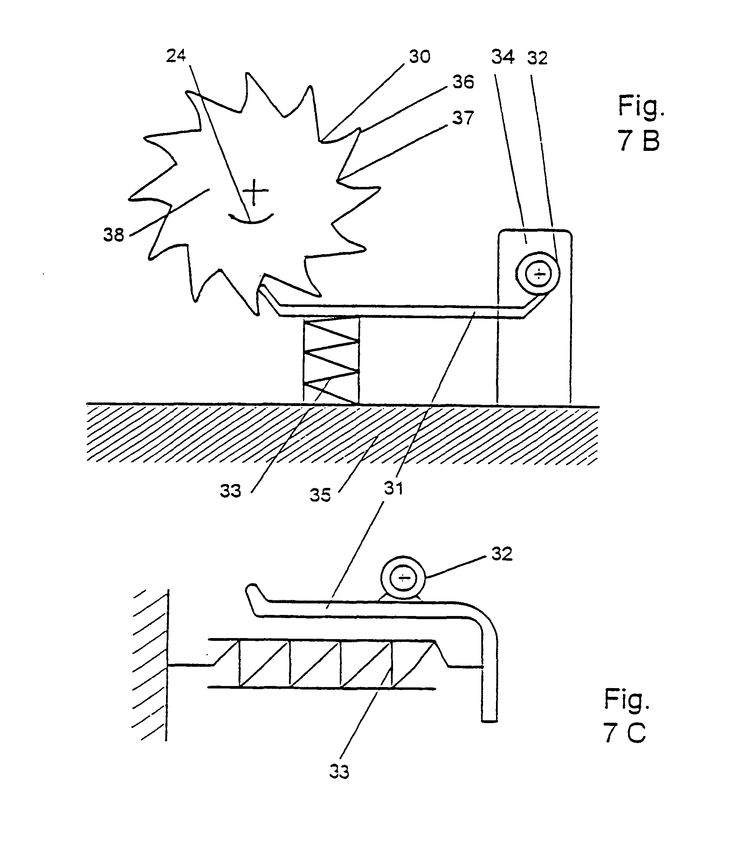

Diese Anordnung ist von der Stirnseite aus gesehen in **Fig. 7A** im Detail dargestellt. In diesem Falle ist die Walze **13,14** von der Ratsche **30** verdeckt. Die Ratsche **30** besteht aus einem Korpus **38** und von dem Korpus **38** abstehenden Zähnen **36.** Ein als Hebel ausgebildeter Klopfer **31** ist an dem Lager **32** auslenkbar angeordnet. Das Lager **32** ist an einem Teil **34** angeordnet, das an einem Einbauteil **35** in der Kammer **1** befestigt ist. Der Klopfer **31** wird über eine Feder **33** gegen den Umfang der Ratsche **30** gedrückt.

Die Ratsche **30** wird durch die Walze **13,14** in Richtung **24** gedreht. Dadurch wird der Klopfer **31** durch die Zähne **36** gegen die Federkraft ausgelenkt. Beim Überspringen eines Zahnes **36** springt der Klopfer **31** in den Zwischenraum **37** zwischen den Zähnen **36** und übt dabei einen Impuls auf die Ratsche **30** und damit auf die Walze **13,14** aus. Der auf die Walze **13,14** übertragene Impuls wird auf die Leiterplatten **LP** übertragen.

Eine alternative Variante für den Klopfer **31** ist in **Fig. 7B** dargestellt. Dieser **Klopfer 31** unterscheidet sich von dem in **Fig. 7A** gezeigten durch die Form.

Eine weitere Variante für den Klopfer **31** ist in **Fig. 7C** dargestellt. Dieser Klopfer **31** ist gegenüber dem in **Fig. 7A** dargestellten durch eine veränderte Art der Übertragung der Federkraft gekennzeichnet.

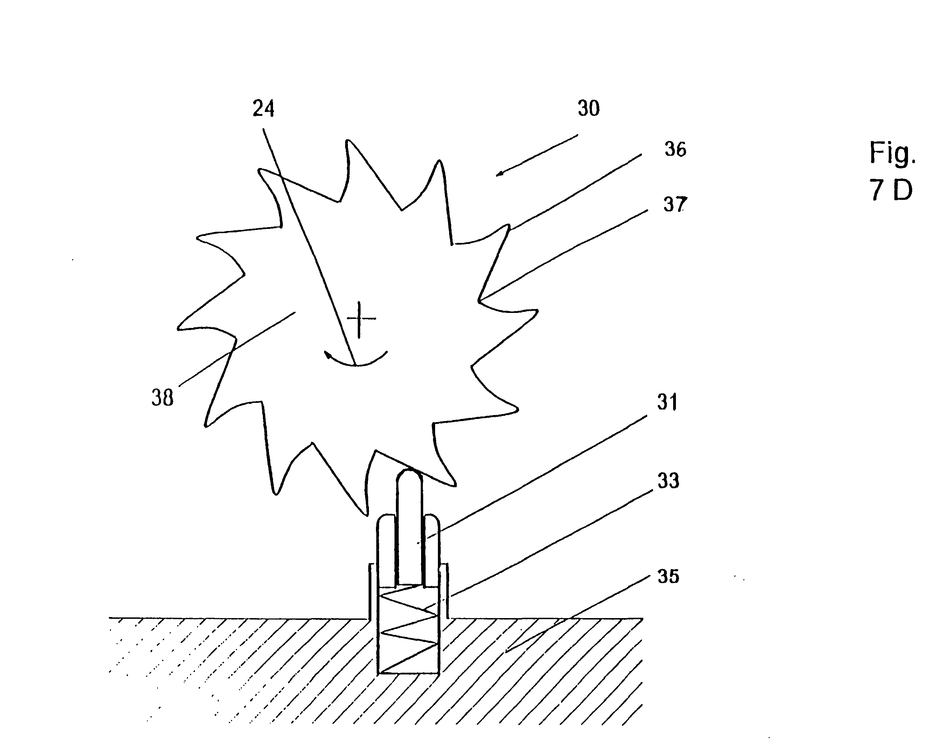

Eine weitere Variante für den Klopfer **31** ist in **Fig. 7D** dargestellt. Dieser Klopfer **31** weist keinen Hebel auf sondern ist als Schlagbolzen ausgebildet, der durch eine Feder **33** vorgespannt ist. Die Feder ist in dem Einbauteil **35** der Kammer **1** gelagert.

Die Ratsche **30** mit dem Korpus **38,** den Zähnen **36** sowie den Zwischenräumen **37** zwischen den Zähnen **36** wird in der Richtung **24** gedreht, indem die Walze **13,14** die Ratsche **30** mitnimmt. Der Schlagbolzen **31** wird durch die Zähne **36** gegen die Kraft der Feder **33** ausgelenkt und schlägt nach dem Übergleiten über die Zähne **36** jeweils in die Zwischenräume **37,** wobei Impulse auf die Ratsche **30,** damit auf die Walze **13,14** und schließlich von dieser auf die Leiterplatte LP übertragen werden.

In **Fig. 8** ist eine weitere Ausführungsform der Erfindung dargestellt. Die obere Walze **14** ist mit einem ferromagnetischen Kern, hier in Form eines Stabmagneten **23** in der hohlen Walze **14**, ausgebildet. Innerhalb des Hohlraumes **20** ist eine Achse **26** vorgesehen, auf der die Walze **14** läuft. Außerdem ist ein Anschlag **43** oberhalb der Achse **26** außerhalb des Walzenkörpers **14** angeordnet. Bei geeigneter Gestaltung des Polschuhes **45** kann der Anschlag **43** auch entfallen. Unterhalb der Achse **27** der unteren Walze **13** ist eine elastische Auflage **42** als Lagereinsatz vorgesehen, um eine Verringerung des Verschleisses der Lager und eine größere Stoßamplitude bei der Impulsübertragung zu erreichen.

In unmittelbarer Nähe zu der oberen Walze **14** ist ferner ein Elektromagnet **40** als Impulserzeugungsmittel angeordnet, der eine Spule **41** und elektrische Zuleitungen **44** aufweist. Durch Einspeisen eines pulsförmigen Stromes in die Spule **41** des Elektromagneten **40** wird ein Magnetfeld am Polschuh **45** des Elektromagneten **40** erzeugt, so daß der Stabmagnet **23** in der oberen Walze **14** vom Elektromagneten **40** angezogen wird. Die Walze **14** wird dadurch angehoben. Bei Beendigung eines Pulses fällt die obere Walze **14** wieder in die Ausgangslage zurück und übt dadurch einen Impuls unmittelbar auf die zwischen den Walzen **13** und **14** transportierten Leiterplatten **LP** (nicht dargestellt) aus.

In **Fig. 9** ist eine weitere Ausführungsform der Erfindung angegeben. In dieser Ausführungsform ist das bereits in den **Fig. 7** und **Fig. 7A - 7D** gezeigte Prinzip zur Impulserzeugung realisiert. Bezüglich der in **Fig. 7** und **7A - 7D** ebenfalls dargestellten Vorrichtungselemente und der dazugehörigen Bezugszeichen wird auf die dortige Figurenbeschreibung verwiesen.

Die Leiterplatten **LP** passieren in diesem Falle eine nur wenige Millimeter (beispielsweise 1 - 3 mm) von der Transportebene **2** entfernt angeordnete vorzugsweise massive Metallplatte **73,** über die Impulse auf die Leiterplatten **LP** über die Behandlungsflüssigkeit übertragen werden. Hierzu ist die Metallplatte **73** zusammen mit einem Amboß **75** innerhalb der Behandlungsflüssigkeit angeordnet. Die Metallplatte **73** ist mit dem Amboß **75** vorzugsweise verschweißt. Der Amboß **75** sollte zumindest teilweise aus der Behandlungsflüssigkeit herausragen. Beide Elemente ruhen normalerweise und sind mit der Behandlungseinrichtung in nicht dargestellter Weise verbunden. Die Metallplatte **73** erstreckt sich über die gesamte Breite des Transportweges, damit Impulse auf der gesamten Breite des Transportweges auf die Leiterplatten **LP** übertragen werden können.

Impulse werden durch ein ratschenartiges Impulserzeugungsmittel **30** erzeugt, das ebenso wie das Impulserzeugungsmittel in den **Fig. 7** und **7A - 7D** ausgeführt sein kann und das dieselbe Funktionsweise aufweist. Über den Hebel **31** und den mit dem Hebel **31** verbundenen Hammer **74** werden Schläge auf den Amboß **75** und die Metallplatte **73** übertragen, so daß Impulse in den Leiterplatten **LP** erzeugt werden können.

### Bezugsziffernliste:

- **1**: Behandlungskammer
- **2**: Transportebene
- **3**: Transportrichtung
- **4**: Eintrittswand an der Kammer **1**
- **5**: Austrittswand an der Kammer **1**
- **6**: Seitenwände der Kammer **1**
- **7**: Boden der Kammer **1**
- **8**: Deckel der Kammer **1**
- **9**: Rohrzuleitung zu den Düsen **10**
- **10**: Düsen
- **11**: Eintrittsschlitz
- **12**: Austrittsschlitz
- **13**: untere Transportmittel/-walzen
- **13'**: untere Transportmittel/-walze am Eintrittsschlitz **11**
- **13"**: untere Transportmittel/-walze am Austrittsschlitz **12**
- **14**: obere Transportmittel/-walzen
- **14'**: obere Transportmittel/-walze am Eintrittsschlitz **11**
- **14"**: obere Transportmittel/-walze am Austrittsschlitz **12**
- **20**: Hohlraum in den Walzen **13,14**
- **21**: Impulserzeugungsmittel, Körper, Metallstab
- **22**: Vorsprung, Stolperleiste
- **23**: innere Auskleidung, ferromagnetischer Kern, Stahlzylinder, Vierkantrohr in den Walzen **13,14,** Stabmagnet
- **24**: Drehrichtung der Walzen **13,14**
- **25**: Innenkante im Vierkantrohr **23**
- **26**: Achse der oberen Walze **14**
- **27**: Achse der unteren Walze **13**
- **30**: mit Vorsprüngen **36** versehenes Rad, Ratsche
- **31**: Impulserzeugungsmittel, Klopfer, Schlagbolzen
- **32**: Lager für den Klopfer **31**
- **33**: Feder am Klopfer **31**
- **34**: Befestigungsteil für den Klopfer **31**
- **35**: Einbauteil zur Befestigung des Klopfers **31**
- **36**: Vorsprung, Zähne am Klopfer **31**
- **37**: Zwischenraum zwischen den Zähnen **36**
- **38**: Korpus des Rades, der Ratsche **30**
- **40**: Impulserzeugungsmittel, Elektromagnet
- **41**: Spule des Elektromagneten **40**
- **42**: elastische Auflage für die Lagerung der unteren Walze **13**
- **43**: Anschlag für die obere Walze 14
- **44**: elektrische Zuleitungen für den Elektromagneten **40**
- **45**: Polschuh des Elektromagneten **40**
- **50**: Impulserzeugungsmittel, Druckluftintervallklopfer
- **51**: Kolben mit steuerbarem Ventil
- **52**: Druckluftzuleitung zum Druckluftintervallklopfer **50**
- **53**: Druckluftableitung vom Druckluftintervallklopfer **50**
- **54**: Aufhängevorrichtung für den Druckluftintervallklopfer **50**
- **55**: Federn an der Aufhängevorrichtung **54**
- **56**: Impulsübertragungsmittel, Schwinger am Druckluftintervallklopfer **50**
- **57**: Impulse
- **58**: Reflexionsmittel
- **60**: Niveau der Behandlungsflüssigkeit
- **70**: Flachstrahldüsen
- **71**: Kammern der Flachstrahldüsen **70**
- **72**: Düsenöffnungen in den Flachstrahldüsen **70**
- **73**: Metallplatte
- **74**: Hammer
- **75**: Amboß

## Patentansprüche

1. Vorrichtung zum Behandeln von durchgehende Löcher und/oder Vertiefungen aufweisenden Schaltungsträgern **(LP)** mit Einrichtungen zum In-Kontakt-Bringen von Behandlungsflüssigkeit mit den Schaltungsträgern **(LP)** sowie Transportmitteln **(13,14)** für die Schaltungsträger **(LP),** mit denen die Schaltungsträger **(LP)** auf einem horizontalen Transportweg und in einer Transportebene **(2)** beförderbar sind, wobei Impulserzeugungsmittel **(21,31,40)** vorgesehen sind, mit denen die Schaltungsträger **(LP)** über die Transportmittel **(13,14)** mechanisch impulsartig anregbar sind.

2. Vorrichtung nach Anspruch 1, **dadurch gekennzeichnet, daß** die Impulserzeugungsmittel **(21,31,40)** derart angeordnet und ausgebildet sind, daß Impulse mit senkrecht auf die Schaltungsträgeroberfläche wirkenden Impulskomponenten erzeugbar sind.

3. Vorrichtung nach einem der vorstehenden Ansprüche, **dadurch gekennzeichnet, daß** die Transportmittel **(13,14)** rotierbar ausgebildet sind und die Impulserzeugungsmittel **(21,31,40)** derart angeordnet und ausgebildet sind, daß die Impulse durch eine Rotation der Transportmittel **(13,14)** erzeugbar und/oder steuerbar sind.

4. Vorrichtung nach einem der vorstehenden Ansprüche, **dadurch gekennzeichnet, daß** die Transportmittel (**13,14**) derart angeordnet und ausgebildet sind, daß die Schaltungsträger (**LP**) in einer im wesentlichen horizontalen Transportebene (**2**) beförderbar sind.

5. Vorrichtung nach einem der vorstehenden Ansprüche, **dadurch gekennzeichnet, daß** die Transportmittel zumindest teilweise mit jeweils einem im wesentlichen zylinderförmigen Hohlraum **(20)** versehene Transportwalzen **(14)** sind, an deren im wesentlichen zylinderförmiger Innenwand sich jeweils mindestens ein Vorsprung **(22)** in axialer Richtung erstreckt und in deren Hohlraum **(20)** jeweils mindestens ein Körper **(21)** als Impulserzeugungsmittel enthalten ist, der beim Rotieren der Transportwalzen **(14)** durch den Vorsprung **(22)** mitgenommen, beim Weiterrotieren den Vorsprung **(22)** überspringen und nach unten auf die Innenwand der Transportwalze **(14)** fallen kann, so daß Impulse auf die Transportwalzen **(14)** und von den Transportwalzen **(14)** auf die Schaltungsträger **(LP)** übertragbar sind.

6. Vorrichtung nach Anspruch 5, **dadurch gekennzeichnet, daß** der Körper **(21)** im wesentlichen zylinderförmig ausgebildet ist und ein möglichst hohes Gewicht aufweist.

7. Vorrichtung nach einem der vorstehenden Ansprüche, **dadurch gekennzeichnet, daß** die Transportmittel **(13,14)** zumindest teilweise mit jeweils mindestens einem Rad **(30),** das am Umfang mit jeweils mindestens einem Vorsprung **(36)** versehen ist, so verbunden und zusammen mit dem mindestens einen Rad **(30)** mit einer gemeinsamen Achse drehbar so gelagert sind und daß jeweils ein federnder oder federnd gelagerter Klopfer **(31)** als Impulserzeugungsmittel am Umfang des mindestens einen Rades **(30)** so anliegt, daß durch den Klopfer **(31)** beim Übergleiten über den Vorsprung **(36)** mechanische Impulse auf das mindestens eine Rad **(30)** und damit auf die mit dem mindestens einen Rad **(30)** verbundenen Transportmittel **(13,14)** und von den Transportmitteln **(13,14)** auf die Schaltungsträger **(LP)** übertragbar sind.

8. Vorrichtung nach einem der vorstehenden Ansprüche, **dadurch gekennzeichnet, daß** die Transportmittel **(13,14)** zumindest teilweise mit jeweils einem magnetischen Kern **(23)** ausgerüstet sind und daß jeweils mindestens ein Elektromagnet **(40)** als Impulserzeugungsmittel den mit dem magnetischen Kern **(23)** ausgerüsteten Transportmitteln **(13,14)** derart zugeordnet ist, daß mit einer pulsförmigen Einspeisung von Strom in den mindestens einen Elektromagneten **(40)** eine Kraft auf die mit dem magnetischen Kern **(23)** ausgerüsteten Transportmittel **(13,14)** in der Weise ausübbar ist, daß über die Transportmittel **(13,14)** mechanische Impulse in den Schaltungsträgern **(LP)** erzeugt werden.

9. Vorrichtung nach Anspruch 8, **dadurch gekennzeichnet, daß** auf die Transportmittel **(13,14)** eine zu den Schaltungsträgern **(LP)** gerichtete weitere Kraft wirkt und daß die Transportmittel **(13,14)** von den Schaltungsträgem **(LP)** mit der von dem mindestens einen Elektromagneten (**40**) ausübbaren Kraft abhebbar und beim Abschalten des mindestens einen Elektromagneten **(40)** durch die weitere Kraft zu den Schaltungsträgern **(LP)** wieder zurückbewegbar sind und daß auf diese Weise mechanische Impulse auf die Schaltungsträger **(LP)** übertragbar sind.

10. Vorrichtung nach Anspruch 9, **dadurch gekennzeichnet, daß** die auf die Transportmittel **(13,14)** wirkende und zu den Schaltungsträgern **(LP)** gerichtete Kraft die Schwerkraft und/oder eine Federkraft und/oder eine magnetische Kraft ist.

11. Verfahren zum Behandeln von durchgehende Löcher und/oder Vertiefungen aufweisenden Schaltungsträgern, bei dem
a. die Schaltungsträger **(LP)** mit Hilfe von Transportmitteln **(13,14)** für die Schaltungsträger **(LP)** auf einem horizontalen Transportweg und in einer Transportebene **(2)** befördert und
b. dabei mit einer Behandlungsflüssigkeit in Kontakt gebracht werden,
c. wobei die Schaltungsträger (**LP**) mit Impulserzeugungsmitteln **(21,31,40)** mechanisch impulsartig über die Transportmittel **(13,14)** angeregt werden.

12. Verfahren nach Anspruch 11, **dadurch gekennzeichnet, daß** mit den Impulserzeugungsmitteln **(21,31,40)** Impulse mit senkrecht auf die Schaltungsträgeroberfläche wirkenden Impulskomponenten erzeugt werden.

13. Verfahren nach einem der Ansprüche 11 und 12, **dadurch gekennzeichnet, daß** rotierende Transportmittel **(13,14)** eingesetzt werden und daß die Impulse durch die Rotation der Transportmittel **(13,14)** erzeugt und/oder gesteuert werden.

14. Verfahren nach einem der Ansprüche 11 bis 13, **dadurch gekennzeichnet, daß** die Schaltungsträger (**LP**) in einer im wesentlichen horizontalen Transportebene **(2)** befördert werden.

15. Verfahren nach einem der Ansprüche 11 bis 14, **dadurch gekennzeichnet, daß**
a. als Transportmittel zumindest teilweise mit jeweils einem im wesentlichen zylinderförmigen Hohlraum **(20)** mit einer im wesentlichen zylinderförmigen Innenwand versehene Transportwalzen **(14)** eingesetzt werden,
b. jeweils mindestens ein Körper **(21)** als Impulserzeugungsmittel in dem Hohlraum **(20)** beim Rotieren der Transportwalzen **(14)** an der Innenwand abrollt und
c. dabei über einen sich an der Innenwand in axialer Richtung erstrekkenden Vorsprung (**22**) springt,
d. so daß beim Herunterfallen und Auftreffen des mindestens einen Körpers **(21)** auf der Transportwalzen-Innenwand Impulse auf die Transportwalzen **(14)** und von den Transportwalzen **(14)** auf die Schaltungsträger **(LP)** übertragen werden.

16. Verfahren nach Anspruch 15, **dadurch gekennzeichnet, daß** der Körper **(21)** im wesentlichen zylinderförmig ausgebildet wird.

17. Verfahren nach einem der Ansprüche 11 bis 16, **dadurch gekennzeichnet, daß**
a. die Transportmittel **(13,14)** zumindest teilweise mit jeweils mindestens einem Rad **(30)** verbunden und zusammen mit dem Rad **(30)** mit einer gemeinsamen Achse drehbar gelagert werden,
b. wobei das mindestens eine Rad **(30)** am Umfang mit jeweils mindestens einem Vorsprung **(36)** versehen wird,
c. jeweils ein federnder oder federnd gelagerter Klopfer **(31)** als Impulserzeugungsmittel am Umfang des mindestens einen Rades **(30)** anliegt und bei Drehung des mindestens einen Rades **(30)** über den mindestens einen Vorsprung **(36)** gleitet und
d. durch den Klopfer **(31)** beim Abgleiten von dem Vorsprung **(36)** mechanische Impulse auf das mindestens eine Rad **(30)** und damit auf die mit dem mindestens einen Rad **(30)** verbundenen Transportmittel **(13,14)** und von den Transportmitteln **(13,14)** auf die Schaltungsträger **(LP)** übertragen werden.

18. Verfahren nach einem der Ansprüche 11 bis 17, **dadurch gekennzeichnet,**
a. daß die Transportmittel **(13,14)** zumindest teilweise mit jeweils einem magnetischen Kern **(23)** ausgerüstet werden und
b. daß jeweils mindestens ein Elektromagnet **(40)** als Impulserzeugungsmittel den mit dem magnetischen Kern **(23)** ausgerüsteten Transportmitteln **(13,14)** derart zugeordnet wird, daß mit einer pulsförmigen Einspeisung von Strom in den mindestens einen Elektromagneten (**40**) eine Kraft auf die mit dem magnetischen Kern **(23)** ausgerüsteten Transportmittel **(13,14)** in der Weise ausgeübt wird, daß über die Transportmittel **(13,14)** mechanische Impulse in den Schaltungsträgern **(LP)** erzeugt werden.

19. Verfahren nach Anspruch 18, **dadurch gekennzeichnet,**
a. daß auf die Transportmittel **(13,14)** eine zur den Schaltungsträgern (**LP**) gerichtete weitere Kraft wirkt,
b. daß die Transportmittel (**13,14**) von den Schaltungsträgem (**LP**) mit der von dem mindestens einen Elektromagneten (**40**) ausgeübten Kraft abgehoben und beim Abschalten des mindestens einen Elektromagneten **(40)** durch die weitere Kraft zu den Schaltungsträgern **(LP)** wieder zurückbewegt werden und
c. daß auf diese Weise mechanische Impulse auf die Schaltungsträger **(LP)** übertragen werden.

20. Verfahren nach Anspruch 19, **dadurch gekennzeichnet, daß** die Schwerkraft und/oder eine Federkraft und/oder eine magnetische Kraft auf die Schaltungsträger (**LP**) wirkt.

21. Verwendung der Vorrichtung nach einem der Ansprüche 1 bis 10 zur Förderung der Benetzung von, zur Entfernung von Gasblasen aus und/oder zur Erhöhung des Stoffaustausches in durchgehenden Bohrungen und/oder Sackbohrungen in Leiterplatten (LP).

22. Anwendung des Verfahrens nach einem der Ansprüche 11 bis 20 zur Förderung der Benetzung von, zur Entfernung von Gasblasen aus und/oder zur Erhöhung des Stoffaustausches in durchgehenden Bohrungen und/oder Sackbohrungen in Leiterplatten (LP).

## Claims

1. Device for treating circuit carriers (PCB) which have through holes and/or depressions, said device having means for bringing treatment fluid into contact with the circuit carriers (PCB) as well as conveying means (13, 14) for the circuit carriers (PCB), by means of which the latter may be conveyed on a horizontal conveying path and in a plane of conveyance (2), wherein pulse generating means (21, 31, 40) are provided by means of which the circuit carriers (PCB) may be excited by mechanical pulses via the conveying means (13, 14).

2. Device according to claim 1, **characterised in that** the pulse generating means (21, 31, 40) are arranged and designed in such a way that pulses may be generated which have pulse components acting vertically on the surface of the circuit carrier.

3. Device according to one of the preceding claims, **characterised in that** the conveying means (13, 14) are designed to be rotatable and the pulse generating means (21, 31, 40) are so arranged and designed that the pulses may be generated and/or controlled by a rotation of the conveying means (13, 14).

4. Device according to one of the preceding claims, **characterised in that** the conveying means (13, 14) are so arranged and designed that the circuit carriers (PCB) may be conveyed in a substantially horizontal plane of conveyance (2).

5. Device according to one of the preceding claims, **characterised in that** the conveying means are at least partially feed rollers (14) each provided with a substantially cylindrical cavity (20) and having at least one projection (22), which extends in an axial direction from its substantially cylindrical inner wall, and containing in its cavity (20) at least one body (21) as a pulse generating means which is taken along by the projection (22) on rotation of the feed rollers (14), and on further rotation of said rollers can spring over the projection (22) and drop down onto the inner wall of the feed roller (14) such that pulses may be transmitted to the feed rollers (14) and from the feed rollers (14) to the circuit carriers (PCB).

6. Device according to claim 5, **characterised in that** the body (21) is designed substantially cylindrical and has the highest possible weight.

7. Device according to one of the preceding claims, **characterised in that** the conveying means (13, 14) are at least partially so connected to at least one wheel (30) each, which is provided with respectively at least one projection (36) on its circumference, and so rotatably mounted with the at least one wheel (30) on a common axis, and **in that** in each case a resilient or resiliently mounted beater (31) so abuts as a pulse generating means against the circumference of the at least one wheel (30), that in sliding over the projection (36), mechanical pulses may be transmitted by the beater (31) to the at least one wheel (30) and thus to the conveying means (13, 14) connected to the at least one wheel (30) and from the conveying means (13, 14) to the circuit carriers (PCB).

8. Device according to one of the preceding claims, **characterised in that** the conveying means (13, 14) are at least partially equipped with a magnetic core (23) each and **in that** respectively at least one electromagnet (40) is associated as a pulse generating means with the conveying means (13, 14) equipped with the magnetic core (23), in such a way that by supplying current in a pulsed manner to the at least one electromagnet (40), a force may be exerted on the conveying means (13, 14) equipped with magnetic core (23), in such a way that mechanical pulses are generated in the circuit carriers (PCB) via the conveying means (13, 14).

9. Device according to claim 8, **characterised in that** an additional force, directed towards the circuit carriers (PCB), acts on the conveying means (13, 14), and **in that** the conveying means (13, 14) may be lifted away from the circuit carriers (PCB) by means of the force which the at least one electromagnet (40) is able to exert, and when the at least one electromagnet (40) is switched off, may be moved back again towards the circuit carriers (PCB) by the additional force, and **in that** mechanical pulses may be transmitted to the circuit carriers (PCB) in this way.

10. Device according to claim 9, **characterised in that** the force acting on the conveying means (13, 14) and directed towards the circuit carriers (PCB) is gravity and/or a spring force and/or a magnetic force.

11. Method for treating circuit carriers which have through holes and/or depressions, wherein
a. the circuit carriers (PCB) are conveyed with the aid of conveying means (13, 14) for the circuit carriers (PCB), on a horizontal conveying path and in a plane of conveyance (2), and
b. in so doing are brought into contact with a treatment fluid,
c. the circuit carriers (PCB) being excited via the conveying means (13, 14) by mechanical pulses from the pulse generating means (21, 31, 40).

12. Method according to claim 11, **characterised in that** pulses which have pulse components acting vertically on the surface of the circuit carrier are generated by the pulse generating means (21, 31, 40).

13. Method according to one of claims 11 and 12, **characterised in that** rotating conveying means (13, 14) are used and **in that** the pulses are generated and/or controlled by the rotation of the conveying means (13, 14).

14. Method according to one of claims 11 to 13, **characterised in that** the circuit carriers (PCB) are conveyed in a substantially horizontal plane of conveyance (2).

15. Method according to one of claims 11 to 14, **characterised in that**
a. feed rollers (14), which are provided at least partially each with a substantially cylindrical cavity (20) having a substantially cylindrical inner wall, are used as the conveying means,
b. respectively at least one body (21) serving as a pulse generating means rolls down the inner wall in the cavity (20) as the feed rollers (14) rotate, and
c. in this process, springs over a projection (22) extending on the inner wall in an axial direction,
d. such that, as the at least one body (21) drops down and strikes the inner wall of the feed roller, pulses are transmitted to the feed rollers (14) and from the feed rollers (14) to the circuit carriers (PCB).

16. Method according to claim 15, **characterised in that** the body (21) is designed substantially cylindrical.

17. Method according to one of claims 11 to 16, **characterised in that**
a. the conveying means (13, 14) are at least partially connected to a wheel (30) each and are rotatably mounted together with the wheel (30) on a common axis,
b. the at least one wheel (30) being provided on its circumference with at least one projection (36),
c. in each case a resilient or resiliently mounted beater (31), serving as a. pulse generating means, abuts against the circumference of the at least one wheel (30) and on rotation of the at least one wheel (30), slides over the at least one projection (36), and
d. mechanical pulses are transmitted by the beater (31), as it slides away from the projection (36), to the at least one wheel (30) and thus to the conveying means (13, 14) connected to the at least one wheel (30), and from the conveying means (13, 14) to the circuit carriers (PCB).

18. Method according to one of claims 11 to 17, **characterised in that**
a. the conveying means (13, 14) are equipped at least partially with a magnetic core (23) each, and
b. **in that** respectively at least one electromagnet (40), serving as a pulse generating means, is associated with the conveying means (13, 14) equipped with the magnetic core (23), in such a way that by supplying current in a pulsed manner to the at least one electromagnet (40), a force is exerted on the conveying means (13, 14) equipped with the magnetic core (23), in such a way that mechanical pulses are generated in the circuit carriers (PCB) via the conveying means (13, 14).

19. Method according to claim 18, **characterised in that**
a. an additional force directed towards the circuit carriers (PCB) acts on the conveying means (13, 14),
b. **in that** the conveying means (13, 14) are lifted away from the circuit carriers (PCB) by means of the force exerted by the at least one electromagnet (40) and are moved back again towards the circuit carriers (PCB) by the additional force when the at least one electromagnet (40) is switched off, and
c. **in that** mechanical pulses are transmitted to the circuit carriers (PCB) in this way.

20. Method according to claim 19, **characterised in that** gravity and/or a spring force and/or a magnetic force acts on the circuit carriers (PCB).

21. Use of the device according to one of claims 1 to 10 for promoting the wetting of, for removing gas bubbles from and/or for increasing the transfer of material in through bores and/or blind bores in printed circuit boards (PCB).

22. Use of the method according to one of claims 11 to 20 for promoting the wetting of, for removing gas bubbles from and/or for increasing the transfer of material in through bores and/or blind bores in printed circuit boards (PCB).

## Revendications

1. Dispositif de traitement de supports de circuits (LP) comportant des trous traversants et/ou des creux avec des dispositifs de mise en contact par le liquide de traitement avec les supports de circuits (LP) ainsi que des moyens de transport (13,14) pour les supports de circuits (LP) avec lesquels les supports de circuits (LP) peuvent être acheminés sur une voie de transport horizontale et dans un niveau de transport (2), moyennant quoi des moyens de génération d'impulsions (21, 31, 40) sont prévus, moyens avec lesquels les supports de circuits (LP) peuvent être excités mécaniquement sous forme d'impulsion via le moyen de transport (13,14).

2. Dispositif selon la revendication 1, **caractérisé en ce que** le moyen de génération d'impulsions (21, 31, 40) est disposé et conçu de sorte que les impulsions peuvent être générées avec des composants à impulsions agissant verticalement sur la surface des supports de circuits.

3. Dispositif selon l'une quelconque des revendications précédentes, **caractérisé en ce que** les moyens de transport (13, 14) sont conçus de façon à pivoter et **en ce que** les moyens de génération d'impulsions (21, 31, 40) sont disposés et conçus de sorte que les impulsions peuvent être générées et/ou commandées par le biais d'une rotation des moyens de transport (13, 14).

4. Dispositif selon l'une quelconque des revendications précédentes, **caractérisé en ce que** les moyens de transport (13,14) sont disposés et conçus de sorte que les supports de circuits (LP) peuvent être acheminés dans un niveau de transport (2) essentiellement horizontal.

5. Dispositif selon l'une quelconque des revendications précédentes, **caractérisé en ce que** les moyens de transport sont des cylindres d'acheminement (14) prévus au moins en partie avec respectivement un espace vide (20) principalement cylindrique, cylindres vers la paroi interne principalement cylindrique desquels une partie saillante (22) s'étend au moins en direction axiale et dans l'espace vide (20) desquels respectivement au moins un corps (21) est contenu comme moyen de génération d'impulsions, lequel peut être entraîné lors de la rotation des cylindres d'acheminement (14) par la partie saillante (22), peut sauter lors de la rotation suivante de la partie saillante (22) et peut tomber vers le bas sur la paroi interne du cylindre d'acheminement (14), de sorte que les impulsions peuvent être communiquées aux cylindres d'acheminement (14) et aux supports de circuits (LP) par les cylindres d'acheminement (14).

6. Dispositif selon la revendication 5, **caractérisé en ce que** le corps (21) est principalement cylindrique et a un poids le plus élevé possible.

7. Dispositif selon l'une quelconque des revendications précédentes, **caractérisé en ce que** les moyens de transport (13, 14) sont reliés au moins en partie avec respectivement au moins une roue (30) prévue à la périphérie avec respectivement au moins une partie saillante (36) et sont assemblés avec au moins une roue (30) de façon à pivoter avec au moins un axe commun, et **en ce que** respectivement un maillet (31) à ressort est placé comme moyen de génération d'impulsions à la périphérie d'au moins une roue (30), de sorte que des impulsions mécaniques peuvent être communiquées par le biais du maillet (31), lors du glissement sur la partie saillante (36), sur au moins une roue (30) et ainsi sur les moyens de transport (13, 14) reliés à au moins une roue (30) et sur les supports de circuits (LP) par les moyens de transport (13, 14).

8. Dispositif selon l'une quelconque des revendications précédentes, **caractérisé en ce que** les moyens de transport (13, 14) sont équipés au moins partiellement avec respectivement un noyau magnétique (23) et **en ce qu'**au moins un électroaimant (40) est affecté comme moyen de génération d'impulsions aux moyens de transports (13, 14) équipés du noyau magnétique (23), de sorte qu'une force peut être exercée sur les moyens de transport (13, 14) équipés du noyau magnétique (23) avec une ligne d'alimentation de courant sous forme d'impulsions dans au moins un électroaimant (40), de sorte que des impulsions mécaniques sont générées dans les supports de circuits (LP) via les moyens de transport (13,14).

9. Dispositif selon la revendication 8, **caractérisé en ce qu'**une autre force orientée vers les supports de circuits (LP) agit sur les moyens de transport (13, 14) et **en ce que** les moyens de transport (13, 14) peuvent être levés des supports de circuits (LP) avec la force exercée par au moins un électroaimant (40) et peuvent être de nouveau abaissés, lors l'arrêt d'au moins un électroaimant (40), par l'autre force vers les supports de circuits (LP), et **en ce que** de cette façon, les impulsions mécaniques peuvent être communiquées sur les supports de circuits (LP).

10. Dispositif selon la revendication 9, **caractérisé en ce que** la force orientée vers les supports de circuits (LP) et/ou agissant sur les moyens de transport (13, 14) est une force de gravité et/ ou une tension du ressort et/ ou une force magnétique.

11. Procédé de traitement de supports de circuits comportant des trous traversants et/ou des creux, dans lequel
a) les supports de circuits (LP) sont acheminés à l'aide de moyens de transport (13, 14) pour les supports de circuits (LP) sur une voie de transport horizontale et dans un niveau de transport (2) et
b) sont ainsi mis en contact avec un liquide de traitement,
c) moyennant quoi les supports de circuits (LP) sont excités avec les moyens de génération d'impulsions (21, 31, 40) par des impulsions mécaniques via les moyens de transport (13, 14).

12. Procédé selon la revendication 11, **caractérisé en ce que** des impulsions sont générées avec des moyens de génération d'impulsions (21, 31, 40) avec des composants à impulsions agissant verticalement sur la surface des supports de circuits.

13. Procédé selon l'une quelconque des revendications 11 et 12, **caractérisé en ce que** des moyens de transport (13, 14) pivotant sont placés et **en ce que** les impulsions sont générées et/ou commandées par la rotation des moyens de transport (13,14).

14. Procédé selon l'une quelconque des revendications 11 à 13, **caractérisé en ce que** les supports de circuits (LP) sont acheminés dans un niveau de transport (2) principalement horizontal.

15. Procédé selon l'une quelconque des revendications 11 à 14, **caractérisé en ce que**
a) des cylindres d'acheminement (14) prévus comme moyens de transport au moins en partie avec respectivement un espace vide (20) principalement cylindrique avec une paroi interne essentiellement cylindrique sont placés,
b) respectivement au moins un corps (21) roule comme moyen de génération d'impulsions dans l'espace vide (20) lors de la rotation des cylindres d'acheminement (14) au niveau de la paroi interne et
c) passe ainsi au-dessus d'une partie saillante (22) s'étendant dans une direction axiale au niveau de la paroi interne,
d) de sorte qu'en cas de chute et d'impact d'au moins un corps (21) sur la paroi interne des cylindres d'acheminement (14), des impulsions sont communiquées sur les cylindres d'acheminement (14) et, par ces derniers, sur les supports de circuits (LP).

16. Procédé selon la revendication 15, **caractérisé en ce que** le corps (21) a une forme principalement cylindrique.

17. Procédé selon l'une quelconque des revendications 11 à 16, **caractérisé en ce que**
a) les moyens de transport (13,14) sont reliés au moins en partie à respectivement au moins une roue (30) et assemblés de façon à pivoter à la roue (30) avec un axe commun,
b) moyennant quoi la roue (30) est prévue à la périphérie avec au moins respectivement une partie saillante (36),
c) respectivement un maillet (31) à ressort est placé comme moyen de génération d'impulsions à la périphérie d'au moins une roue (30) et glisse, lors de la rotation d'au moins une roue (30) sur au moins une partie saillante (36) et
d) des impulsions mécaniques sont communiquées, par le biais du maillet (31) lors du glissement par la partie saillante (36), sur au moins une roue (30) et ainsi sur les moyens de transport (13,14) reliés à au moins une roue (30) et, par ces moyens de transport (13, 14), sur les supports de circuits (LP).

18. Procédé selon l'une quelconque des revendications 11 à 17, **caractérisé en ce que**
a) les moyens de transport (13, 14) sont équipés au moins en partie respectivement d'un noyau magnétique (23) et
b) **en ce que** respectivement au moins un électroaimant (40) est affecté comme moyen de génération d'impulsions aux moyens de transport (13,14) équipés du noyau magnétique (23) de sorte qu'une force est exercée sur les moyens de transport (13, 14) équipés du noyau magnétique (23) avec une ligne d'alimentation de courant sous forme d'impulsions dans au moins un électroaimant (40), de sorte que des impulsions mécaniques sont générées dans les supports de circuits (LP) via les moyens de transport (13,14).

19. Procédé selon la revendication 18, **caractérisé en ce que**
a) une autre force orientée vers les supports de circuits (LP) agit sur les moyens de transport (13, 14),
b) les moyens de transport (13, 14) sont levés des supports de circuits (LP) par une force exercée au moins par un électroaimant (40) et, lors de l'arrêt d'au moins un électroaimant (40), sont abaissés par l'autre force sur les supports de circuits (LP) et
c) des impulsions mécaniques sont ainsi communiquées sur les supports de circuits (LP).

20. Procédé selon la revendication 19, **caractérisé en ce que** la force de gravité et/ou une tension du ressort et/ou une force magnétique agit sur les supports de circuits (LP).

21. Utilisation du dispositif selon l'une quelconque des revendications 1 à 10 pour faciliter l'humectation, pour supprimer les bulles de gaz et/ou pour augmenter les échanges de matières dans les alésages traversants et/ou les alésages à trous borgnes dans les cartes de circuits imprimés (LP).

22. Utilisation du procédé selon l'une quelconque des revendications 11 à 20 pour faciliter l'humectation, pour supprimer les bulles de gaz et/ou pour augmenter les échanges de matières dans les alésages traversants et/ou les alésages à trous borgnes dans les cartes de circuits imprimés (LP).
